(19) Europäisches Patentamt
European Patent Office
Office européen des brevets

(11) **EP 1 831 932 B1**

(12) **EUROPEAN PATENT SPECIFICATION**

(45) Date of publication and mention
of the grant of the patent:
**08.05.2013 Bulletin 2013/19**

(51) Int Cl.:
*H01L 29/76* *(2006.01)*    *G11C 5/14* *(2006.01)*
*G11C 11/4074* *(2006.01)*    *G11C 16/08* *(2006.01)*

(21) Application number: **05856125.9**

(22) Date of filing: **28.12.2005**

(86) International application number:
**PCT/US2005/047671**

(87) International publication number:
**WO 2006/072094 (06.07.2006 Gazette 2006/27)**

(54) **APPARATUS AND METHOD FOR IMPROVING DRIVE STRENGTH, LEAKAGE AND STABILITY OF DEEP SUBMICRON MOS TRANSISTORS AND MEMORY CELLS**

VORRICHTUNG UND VERFAHREN ZUR VERBESSERUNG DER ANSTEUERSTÄRKE, DES LECKENS UND DER STABILITÄT VON TIEF-SUBMIKROMETER-MOS-TRANSISTOREN UND SPEICHERZELLEN

APPAREIL ET PROCEDE DESTINES A AMELIORER LA RESISTANCE D'ATTAQUE, LA FUITE ET LA STABILITE DE TRANSISTORS MOS SUBMICRONIQUES PROFONDS ET DE CELLULES DE MEMOIRE

(84) Designated Contracting States:
**AT BE BG CH CY CZ DE DK EE ES FI FR GB GR HU IE IS IT LI LT LU LV MC NL PL PT RO SE SI SK TR**

(30) Priority: **29.12.2004 US 27181**
          **04.01.2005 US 29542**
          **19.04.2005 US 110457**
          **19.09.2005 US 717769 P**

(43) Date of publication of application:
**12.09.2007 Bulletin 2007/37**

(73) Proprietor: **Semi Solutions LLC.**
**Palo Alto CA 94303 (US)**

(72) Inventors:
• **KAPOOR, Ashok**
**Palo Alto, CA 94303 (US)**

• **STRAIN, Robert**
**San Jose, CA 95120 (US)**
• **MARKO, Reuven**
**42240 Natanya (IL)**

(74) Representative: **Schoppe, Fritz et al**
**Schoppe, Zimmermann, Stöckeler & Zinkler**
**Patentanwälte**
**Postfach 246**
**82043 Pullach bei München (DE)**

(56) References cited:
**US-A- 5 753 955**      **US-A- 5 821 769**
**US-A- 5 969 564**      **US-A- 6 018 168**
**US-A1- 2002 017 678**    **US-B1- 6 787 850**
**US-B2- 7 064 942**

**Description**

## BACKGROUND OF THE INVENTION

### TECHNICAL FIELD

The invention relates generally to MOS based transistors and memory cells. More specifically, the invention relates to the improvement of drive strength, current leakage, and stability of deep submicron MOS transistors and of memory cells using deep submicron MOS transistors.

### DESCRIPTION OF THE PRIOR ART

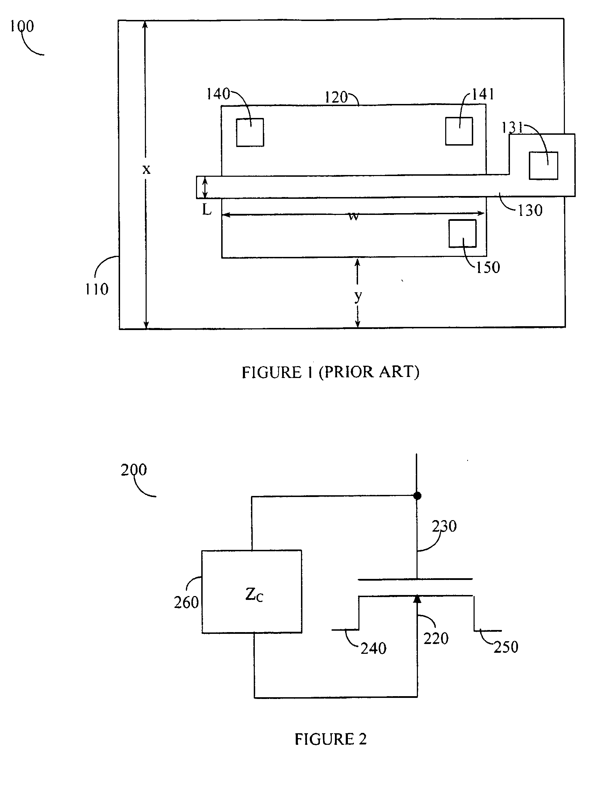

Conventional complementary metal-oxide semiconductor (CMOS) technology currently poses some difficult problems as the minimum feature size shrinks to below 100 nanometers and power supply voltage is reduced to less than 1.0V. A typical layout of a 0.18 micron transistor 100 is shown in Fig. 1. The transistor is manufactured over a well 110 where a diffusion area 120 is created. The gate 130 of the transistor 100 is formed over the well 120 and has a width "w," for example 0.18 micron, as a minimum width for a transistor in a 0.18 micron technology. Contacts 140 and 141 comprise one terminal of the NMOS transistor, for example the drain, and a contact 150 provides another terminal of the transistor 100, for example the source. The contact 131 is connected to the gate 130. There are other minimal feature sizes, such as a minimal size for the well "x" and a minimum distance from the edge of the well to the diffusion area 120 marked as "y." Dimensions such as "w," "x," and "y" are generally process dependent. The power supply voltage is reduced in correspondence with the minimum feature size to maintain a limit on the electrical field across the oxide. Therefore, the power supply voltage has decreased from 3.3V for 0.35-micron CMOS technology to 1.8V for 0.18 micron technology, and is further expected to be at the 1.0V level for 100 nanometers CMOS technology. While power supply voltage decreased, the threshold voltage of the NMOS transistors stayed between 0.45V and 0.35V. The relationship between the NMOS threshold voltage $V_{th}$ and CMOS power supply $V_{DD}$ is known to be very critical. The threshold voltage determines the leakage current, $I_{off}$, of the transistor when it is in its OFF state. As the threshold voltage is driven lower, the leakage current increases.

The drain current of a transistor is a direct function of the overdrive of the transistor, measured as the difference between power supply $V_{DD}$ and threshold voltage $V_{th}$. The drain current of the transistor determines the time required to charge the load capacitance from ground to the level of power supply $V_{DD}$. This overdrive voltage has decreased constantly as the power supply decreased from 3.3V to 1.0V, while threshold voltage decreased only from 0.45V to 0.35V. For 0.1 micron technology, the threshold voltage of the transistors is being scaled below 0.35V at the expense of a very high OFF stage leakage current $I_{OFF}$ which ranges between 10nA to 100nA for a transistor with equal gate length and width, or a W/L ratio of 1. For a transistor with a gate width to length (W/L) ratio of 10, the OFF current increases to ten times the value stated above, *i.e.* from 100nA to 1000nA. For a CMOS technology of 0.1-micron minimum feature size, a typical VLSI chip is expected to contain over 100 million gates. Thus, a leakage of every gate of 1 microamperes results in 100 amperes of leakage current.

A scheme to control the threshold voltage dynamically has been proposed by Takamiya et al. in an article titled High Performance Electrically Induced Body Dynamic Threshold SOI MOSFET (EIB-DTMOS) with Large Body Effect and Low Threshold Voltage. Takamiya *et al.* suggest a scheme that shorts the gate and the substrate of the transistors, thereby causing the substrate voltage of the transistor to increase as the gate voltage is increased for a n-channel MOS (NMOS) transistor. This scheme is proposed for NMOS transistors fabricated on silicon-on-insulator (SOI) substrates where the transistor substrate is totally isolated. This scheme manipulates the threshold voltage by changing the bias of the substrate in the positive direction for a NMOS transistor along with a positive signal at the gate. As the substrate to source voltage becomes positive, the depletion layer width is reduced. This results in a lower threshold voltage of the transistor, thereby increasing the current from the transistor. In the native form, the Takamiya *et al.* invention is applicable only for circuits using power supply voltage of less than 0.6V because this scheme turns on the substrate-to-source diode. The leakage from this diode must be limited. Otherwise, one type of leakage would be traded for another, *i.e.* from drain-to-source leakage to substrate-to-source leakage.

Douseki in U.S. patent no. 5,821,769 describes a method for the control of the threshold voltage of a MOS transistor by connecting a MOS transistor between the gate and the substrate to control the threshold voltage. The Douseki invention requires the addition of another transistor for every transistor whose threshold voltage is dynamically controlled. The adjusted threshold voltage is fixed by the power supply voltage and the threshold voltage of the additional transistor. The area penalty is fairly large for the Douseki invention, although it can be executed without additional process steps.

Notably, MOS technology has enabled the increase in the density of semiconductor memory chips with every step of scaling down of the minimum geometry of the transistors. The increase in density has taken place for dynamic random access memory (DRAM), static random access memory (SRAM), and non-volatile memory (NVM) chips. In fact, the memory chips have proven to be a major driver in shrinking geometry of MOS transistors. With the transistor minimum dimension scaled below 100 nanometers, the density of dynamic random access memory has reached four gigabits. The maximum current conducted by the transistor, $I_{ON}$ is not increasing rapidly due to various second order effects that are becoming dominant. As a result, the transistors are being designed with lower threshold voltage $V_{TH}$. This results in the increase of the leakage current $I_{OFF}$.

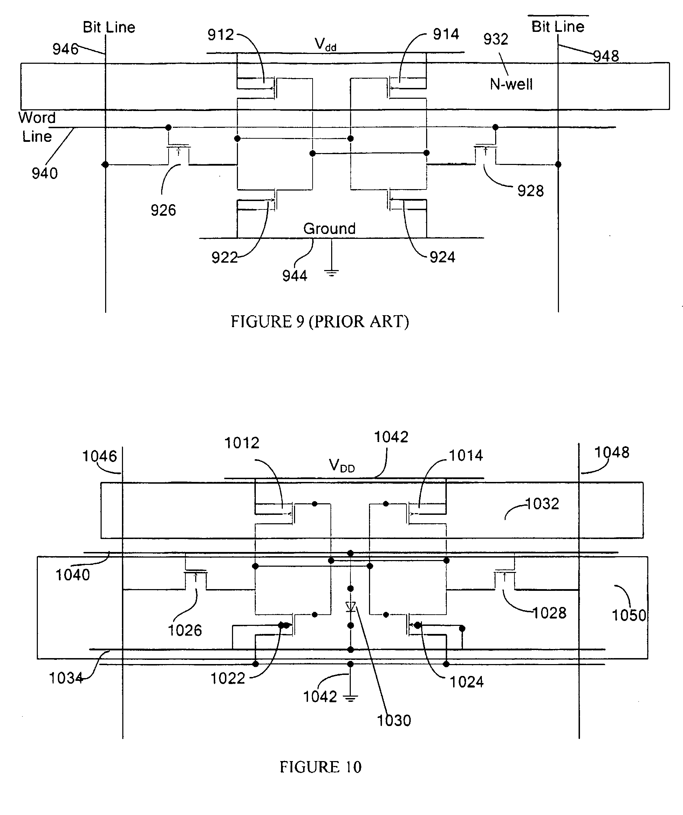

Figure 9 illustrates a typical SRAM element, also known as SRAM cell. This cell consists of two cross-coupled CMOS inverters consisting of NMOS transistors 222 and 224 and PMOS transistors 212 and 214. The memory cell is accessed using the pass transistors 226 and 228. These six transistors form a static random access memory. The PMOS transistors are formed in a n-well 232, which is shared by a certain number of SRAM cells. The cell is powered by the power bus, a metal line marked 242, and the ground connection is provided by the bus 244. The data to the cell are read and written by bit lines 246, representing the bit line value itself, and line 248 representing the inverse value of bit line 246, otherwise also know as a bitline bar.

It is well known to those skilled in the art that SRAM cells, such as the SRAM cells shown in Fig. 9, are critically dependent upon the ratio of $I_{ON}$ to $I_{OFF}$, and a higher value of this ratio is desirable for the stability of the memory cell. With the lowered ratio of $I_{ON}$ to $I_{OFF}$, memory cells are not very stable and are subject to change of their state, or flipping, due to small electrical disturbances.. Similarly, DRAM devices are also dependent upon the conducting characteristics of the MOS transistors. In a DRAM, a capacitor for storing the charge is used, and a transistor acts as a gating element to make or break the electrical connection to the capacitor. These pass transistors are designed with a high threshold voltage so that the off current of these transistors is low. This results in lowering of the ON current of these transistors, which leads to decrease in the read and write speed to me DRAM.

US 2002/017678 A1 describes an apparatus according to the preamble of claim 1 and of forming field effect transistors and resultant field effect transistor circuitry. A semiconductive substrate includes a field effect transistor having a body. A first resistive element is received by the substrate and connected between the transistor's gate and the body. A second resistive element is received by the substrate and connected between the body and a reference voltage node. The first and second resistive elements form a voltage divider which is configured to selectively change threshold voltages of the field effect transistor with state changes in the gate voltage. In a preferred embodiment, first and second resistive elements are implemented as Polysilicon diode assemblies positioned over the substrate and connected between the gate and body, and the body and a reference voltage node to provide the voltage divider.

US 6,787,850 B1 describes a semi-conductor device comprising on a substrate a first dynamic threshold voltage MOS transistor, with a gate, and a channel of a first conductivity type, and a current limiter means connected between the gate and the channel of said first transistor. The first transistor is fitted with a first doped zone of the first conductivity type, connected to the channel, and the current limiter means comprises a second transistor with a second doped zone of a second conductivity type, placed against the first doped zone and electrically connected to the first zone by an ohmic connection. In a second embodiment the second transistor is replaced by a diode.

## SUMMARY OF THE INVENTION

It is an object of the invention to provide a technology which can reduce the leakage of MOS transistors without adversely affecting the drive current or the drain current under saturation conditions, and which can reduce the leakage of memory cells using deep submicron MOS transistors, without adversely affecting other characteristics of the memory cell.

This object is achieved by an apparatus of claim 1, and by a method of claim 8.

Embodiments of the invention provide for a technology which can reduce the leakage of MOS transistors without adversely affecting the drive current or the drain current under saturation conditions, which conditions are stated as drain-source voltage and gate-source voltage equal to the power supply voltage ($V_{DS} = V_{GS} = V_{DD}$).

Embodiments of the invention provide for a technology which can reduce the leakage of memory cells using deep submicron MOS transistors, without adversely affecting other characteristics of the memory cell. Preferably such a solution will not change standard manufacturing processes and, preferably, such technology will be further applicable to multiple types of memory cells.

An apparatus and method for manufacturing metal-oxide semiconductor (MOS) transistors that are operable at voltages below 1.5V, which MOS transistors are area efficient, and where the drive strength and leakage current of the MOS transistors is improved. The invention uses a dynamic threshold voltage control scheme that does not change the existing MOS technology process. The invention provides a technique that controls the threshold voltage of the transistor. In the OFF state, the threshold voltage of the transistor is set over 0.45V, keeping the transistor leakage to less than 0.1 nA/micron width. In the ON state, the threshold voltage is set to less than 0.25V, resulting in increased drive strength. The invention is particularly useful in MOS technology for both bulk and silicon on insulator (SOI) CMOS. The invention is further useful for a variety of digital and analog designs including but not limited to logic gates, SRAM, DRAM, and NVM devices.

## BRIEF DESCRIPTION OF THE DRAWINGS

Figure 1 shows a typical layout of a 0.18 micron transistor (prior art);

Figure 2 is a schematic diagram of a control circuit $Z_C$ connected between the gate and substrate terminals of a NMOS transistor in accordance with the disclosed invention;

Figure 3 is a schematic diagram of the control circuit $Z_C$ of Figure 2;

Figure 4A is a cross-section of a NMOS transistor having a diffused diode control circuit $Z_C$;

Figure 4B is a cross-section of a PMOS transistor having a diffused diode control circuit $Z_C$;

Figure 4C is a cross-section of a NMOS transistor having a self-aligned diode control circuit $Z_C$;

Figure 4D is a cross-section of a NMOS transistor having a poly diode control circuit $Z_C$;

Figure 4E is a cross-section of a NMOS transistor having a Schottky diode control circuit $Z_C$;

Figure 5 shows an exemplary layout of a MOS transistor having a control circuit $Z_C$;

Figure 6 shows an exemplary implementation of the invention in a CMOS buffer;

Figure 7 shows an exemplary implementation of the invention in a CMOS NAND gate;

Figure 8 shows an exemplary implementation of the invention in a CMOS pass gate;

Figure 9 shows a standard CMOS SRAM cell (prior art);

Figure 10 shows a CMOS SRAM cell having a dynamic threshold control to improve the speed and stability of the cell;

Figure 11 shows an exemplary implementation of the invention in an array of cells in a SRAM;

Figure 12 shows an exemplary implementation of a dual port SRAM with a dynamic threshold control;

Figure 13 shows an exemplary DRAM cell with a dynamic threshold control;

Figure 14 shows an exemplary non-volatile memory cell with a dynamic threshold control;

Figure 15 shows cross-coupled CMOS inverters forming a SRAM cell (prior art);

Figure 16 shows a representative current - voltage characteristics of transistor drain current, gate tunneling current, and gate biasing forward and reverse biasing current;

Figure 17 shows a circuit configuration of NMOS and PMOS transistors with the diode connected to the gate, where the diode has very low forward drop and very high reverse current;

Figure 18 shows a SRAM cell having a diode connected in series with the gate of the NMOS transistors in the inverter to reduce gate leakage;

Figure 19A shows a voltage waveform at the input and output of a CMOS inverter;

Figure 19B shows a voltage waveform at the input and output of a CMOS inverter with diode coupled gate;

Figures 20A-20C shows the cross sections of NMOS and PMOS transistors having diodes in accordance with an exemplary implementation;

Figure 21 shows an exemplary control circuits $Z_C$ implemented in accordance with the disclosed invention;

Figure 22 shows an exemplary layout of a control circuit $Z_C$ that includes a capacitor in accordance with the disclosed invention;

Figure 23 shows a cross-section showing two lateral poly diodes;

Figure 24 shows a cross-section showing a capacitor and a single lateral poly diode;

Figure 25 shows a schematic diagram of an exemplary implementation of a positive well bias and a negative well bias in accordance with the disclosed invention; and

Figure 26 shows an exemplary implementation of a CMOS buffer using a positive well bias and a negative well bias in accordance with the disclosed invention.

## DETAILED DESCRIPTION OF THE INVENTION

The core of the disclosed invention is the addition of a circuit to the NMOS transistor that results in the increase of the drive current while in an ON state, and a reduction of the leakage current while in the OFF state. Specifically, this is achieved by implementing a control circuit between the gate and the substrate of the transistor. The control circuit can include one or more diodes. Specifically, the circuit forces a high threshold voltage $V_{TH}$ in the OFF state of the NMOS transistor and a low $V_{TH}$ in the ON state of the NMOS transistor. A detailed description of the disclosed invention follows.

Fig. 2 is an exemplary and non-limiting schematic diagram of a circuit 200 in accordance with the disclosed invention. A control circuit $Z_C$ 260 is connected to a NMOS transistor comprising a substrate 220, a gate 230, a drain 240, and a source 250. The control circuit is connected between the gate 230 and the substrate 220. In accordance with the disclosed invention, the control circuit $Z_C$ implements a dynamic voltage control by using, for example, various types of diodes to control substrate voltage. By controlling the threshold voltages to be different in the ON and OFF states of the controlled NMOS transistor, improvement in drive current in the ON state and leakage current in the OFF state is achieved. Furthermore, there is provided an extremely area efficient implementation of dynamic threshold voltage control, as described in further detail below. The threshold voltage is modulated by changing the net charge in the depletion layer beneath the gate. This is commonly known as "body effect," and its strength, that is, the change in threshold voltage associated with a change in the effective substrate voltage, is increased by higher values of substrate doping in the region immediately beneath the gate.

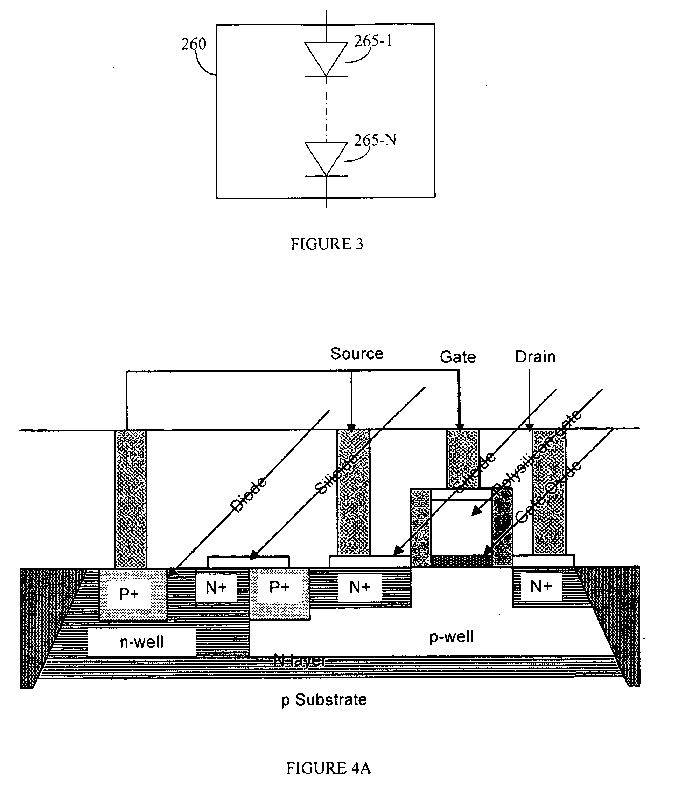

Fig. 3 shows an exemplary control circuit 260 comprised of a plurality of diodes 265. The control circuit 260 may comprise of one or more diodes connected between the gate 230 and the substrate 220 of the NMOS transistor. The dynamically adjusted threshold voltage is varied by adjusting the diode layout geometry. No variations in the manufacturing process are required, however, in one embodiment of the invention, discussed in more detail below, such variations are shown, and provide additional benefits to the disclosed invention.

The diodes are fabricated in a variety of techniques as detailed further. One such type is that of diffused diodes. These diodes are conventional diodes that are fabricated by diffusing n-type and p-type layers in an isolated structure. The voltage across the diodes is controlled by adjusting the doping profiles in silicon and programming the area, thereby controlling the voltage drop across the diode.

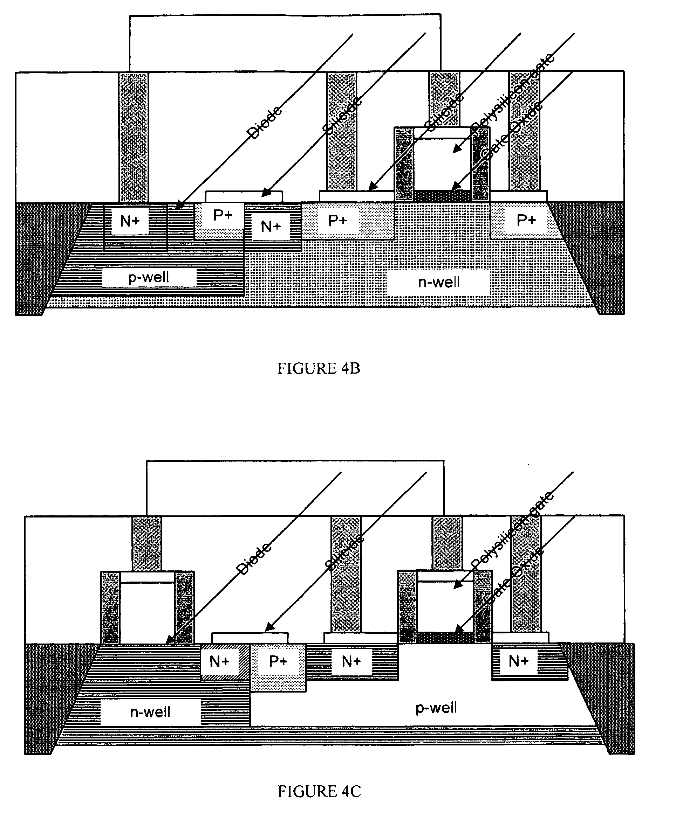

Figs. 4A and 4B show exemplary and non-limiting cross sections of a circuit 200 using such diffused diodes. The diffused diodes are conventional diodes that are used to adjust the bias voltage at the well. The diodes are formed differently for NMOS and PMOS transistors. The NMOS transistors are formed in a region isolated from the p-type substrate by a deep N type implant. This isolation is achieved by existing triple well CMOS technology, as is known to those skilled in the art. This isolation can also be achieved by a deep N type implant in the region of NMOS transistors consisting of phosphorous with an implant dose ranging from $1\times10^{11}/cm^2$ to $1\times10^{14}/cm^2$ and an energy ranging from 50 KeV to 5 MeV. This implant is annealed at temperatures ranging from 900°C to 1150°C for 15 seconds to 2 hours. In one example, the diodes for use with NMOS structures are formed in an area adjoining the NMOS, next to the well tap in the same isolation area or another suitable location. The area containing the diode additionally receives the n-well implant to form the cathode. One exemplary but non-limiting implementation uses the process step which is used to form the n-well region for PMOS transistors. This is done by using, for example, phosphorous or arsenic ions with doping in the range of 1E11 /cm$^2$ and 5E14 /cm$^2$ at an implant energy in the range of 25 KeV and 400 KeV. The N type isolation implant and the N-well implant form a contiguous N type semiconductor region. An n+ contact region is formed in the implanted n-well region near the surface to provide the Ohmic contact for the cathode. The anode region is formed by the p+ implant that is used for making the p+ source/drain regions for the PMOS transistor. The anode and cathode regions are formed using the source and drain implants for PMOS and NMOS, respectively. The implant dose and energy are determined by the electrical characteristics of the transistor. This diode can be connected to the well contact with standard metallization, or in order to save space, a silicide strap formed by *in-situ,* self-aligned silicidation of silicon by reacting it with titanium, cobalt, nickel, or any other suitable metal may be provided to short the cathode of the diode with the well contact of the NMOS.

In a PMOS implementation shown in Fig. 4B, the transistor itself is isolated by the virtue of being formed in the N-well and no additional steps are needed to form the isolation region for the transistor and the diode from the substrate. In an exemple, the anode region of the diode is formed by the anti-punch through boron implant used for NMOS transistors or another suitable implant step. To insure a contiguous P type region for the diode in the N-well, an additional p-type implant using boron or indium with dose in the range of 1E12 to 1E15/cm$^2$ and implant energy in the range of 5KeV to 200KeV may be used to form the anode region of this diode. The Ohmic contact to the anode region is formed by the source/drain implant for the PMOS transistor. The cathode region of the diode is formed by the n+ implant, which is the same implant as the source/drain implant for the NMOS transistor. A silicide strap formed by in-situ self aligned silicidation of silicon by reacting it with titanium, cobalt, nickel, or any other suitable metal is provided to short the anode of the diode with the well contact of the PMOS.

Another type of diode is that of integrated polysilicon diodes. These diodes are formed by the contact of n-type and p-type polysilicon to underlying silicon of opposite polarity. The polysilicon layers are the same as those that are used to build the gate of the MOS transistors. These diodes are formed by preventing the formation of the gate oxide underneath the transistor gates or by removing the oxide prior to the deposition of polysilicon. The voltage across the diodes is adjusted by controlling the doping profiles in silicon and programming the area of the diodes.

Fig. 4C shows an exemplary and non-limiting cross section of a circuit 200 using a self-aligned diode control circuit $Z_C$. The diodes are formed by depositing polysilicon on top of the regions where gate oxide has been prevented from growing during the thermal oxidation cycle, or where it has been removed prior to the deposition of polysilicon by an appropriate process step. The wafers are processed through a typical CMOS process by implanting well regions and forming the isolation oxide by any of the established processes. An additional process step is performed to form the isolation region where NMOS transistors are to be formed, and is carried out as described in the previous paragraph. Next, the threshold adjust implants are made. The growth of silicon dioxide on selected areas is accomplished by selectively implanting the area of silicon where the oxide is to be prevented from growth with a photoresist mask covering the rest of the wafer. This is achieved by implanting this region with nitrogen atoms by ion implantation to a dose of 1 E14 /cm$^2$ to 1E16/cm$^2$ at an implant energy of 2KeV to 50 KeV. The wafers are then taken through the gate oxidation cycle, as may be required by the process, to achieve the appropriate electrical characteristics of the transistor. Thus, oxidation of the implanted regions is prevented while the oxidation of silicon region on the remaining wafer takes place. Alternately, the gate oxide is etched selectively using a mask from the region where the oxide has to be removed. A layer of polysilicon is deposited next on the wafer and the regular CMOS process steps are conducted. The polysilicon layer is doped to form conductivity region n+ and p+ for NMOS and PMOS transistor gates, respectively. An Ohmic electrical connection between the diode terminal and the well terminal is accomplished with the help of the self-aligned silicide, which is an essential part of the CMOS process step.

In an alternate embodiment of the invention, the gate oxide underneath the polysilicon on top of the diode region is damaged by the appropriate dopant type to change the electrical characteristic of the oxide to allow it to conduct electrical charge. For the NMOS transistors, a phosphorous or arsenic implant and for PMOS transistors, a boron implant of dose $1 \times 10^{13}$ to $1 \times 10^{16}$ atoms/cm$^2$ with an energy ranging from 25KeV to 200KeV is used to implant the polysilicon layer and damage the underlying gate oxide in the region of the diode to form an electrically conducting electrode. In another embodiment of the invention, an inert atom such as argon is used to damage the gate oxide, using implant energy and dose deemed essential to cause irreparable damage to the gate oxide layer.

Yet another type of diode is the in-line polysilicon diode. These are the most area and process efficient structures created by implanting n-type and p-type dopant separated laterally in a line of polysilicon. The voltage drop across the diodes is controlled by programming the location of the n-type and p-type implants and their doses used to form the diodes.

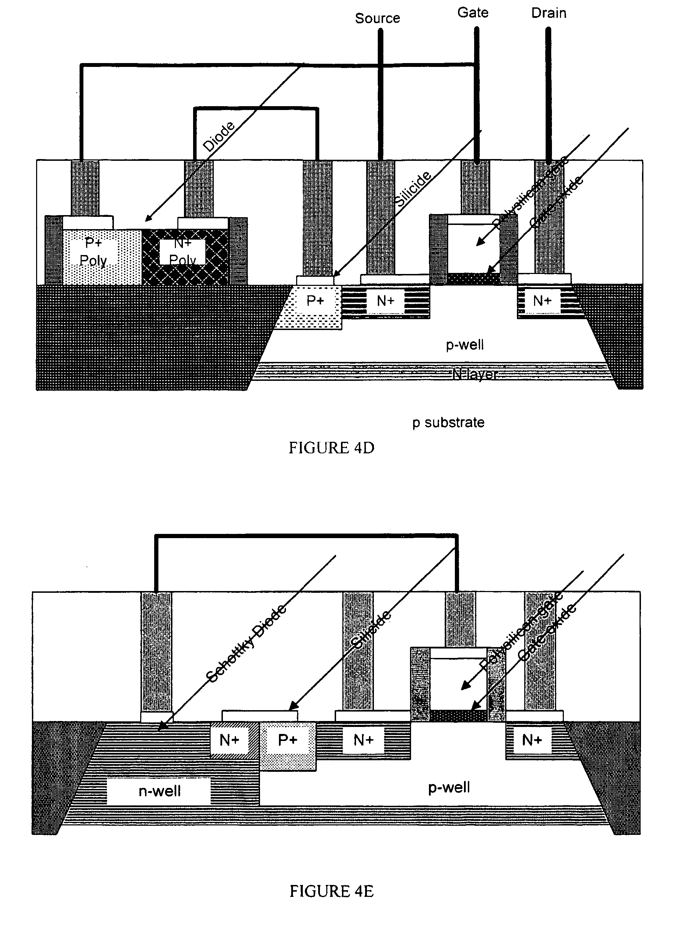

Fig. 4D is an exemplary and non-limiting cross section of a circuit 200 using a poly diode control circuit $Z_C$. In one example, a lateral diode is formed in a line of polysilicon between n+ and p+ polysilicon regions, where the electrical characteristics of the polysilicon diode are controlled by the lateral isolation between the n+ and p+ regions in polysilicon. The p+ and the n+ regions of polysilicon are formed by the source/drain implants of the NMOS and PMOS transistors. The polysilicon is doped, for example, with phosphorous, arsenic, or antimony to a dose in the range of $5 \times 10^{14}$ to $5 \times 10^{16}$/cm$^2$ at an energy in the range of 5KeV to 200 KeV. The p+ region is formed by doping polysilicon with boron or indium to a dose in the range of $1 \times 10^{14}$ to $5 \times 10^{16}$/cm$^2$ at an energy in the range of 5 KeV to 200 KeV. The thickness of the polysilicon layer is determined by the transistor electrical characteristics. For 0.13 micron to 0.07 micron drawn dimensions, the thickness of the polysilicon layer is in the range of 1000 angstroms to 4000 angstroms. The space between the n+ and p+ implant regions is between - 0.5 micron (overlap) to +2.0 micron (separation) and it is programmed during mask layout. The lateral-masking dimension controls the barrier height of polysilicon diode. The layer of polysilicon is implanted with n+ and p+ on two sides having a lateral separation. A diode is formed at the intersection of the two regions. The forward characteristics of this diode are dependent upon the level of doping of the two impurity types in polysilicon and the separation between the two regions. Coincident mask layers (Is =0) or overlapping mask layers (negative Is) produce diodes having very high reverse leakage and low forward drop. On the other hand, with increasing separation of the n+ and p+ regions, the reverse leakage of the diode decreases and the forward drop across the diode increases.

Alternately, polysilicon layer is uniformly implanted in the region of the diode by an N-type (P-type) dopant, as the case may be, with a lower implant dose, such as $1 \times 10^{13}$ - $5 \times 10^{15}$ atoms/cm$^2$ of appropriate doping species, and the desired region for the formation of anode (cathode) is implanted with a heavier dose of the P (N) type species with the dose of $2 \times 10^{13}$/cm$^2$ - $5 \times 10^{16}$ atoms/cm$^2$. This arrangement does not require alignment of the N and P type implants and relies strictly on the dopant concentration to determine the diode characteristics.

The isolation of the NMOS transistor obtained by this technique leaves the N type layer underneath the NMOS transistor floating or not in Ohmic contact with any node with a well-defined voltage. This configuration is used in the example where the maximum voltage on the drain of the NMOS transistor is $V_{DD}$ ($\leq$ 1.5V) that is less than two times the breakdown voltage of the p-n junction. One appropriate application of the example is for systems using $V_{DD}$ at or below 1.0V, where the possibility of any parasitic action due to incidental forward biasing of any p-n junction is negligible. However, to safeguard against forward biasing of any parasitic p-n junction, an alternate embodiment of the invention includes the formation of a deep Ohmic contact extending from the drain of the NMOS transistor and connecting with the isolation N-layer underneath the NMOS. This N-type tap is formed by a multiplicity of deep ion implants of phosphorous or arsenic atoms in selected areas of the drain, such that the transistor characteristics are not adversely impacted. The exact ion implant dose and energy of this N-tap is dependant upon the device structure, and is expected to be in the range of $1 \times 10^{11}$ /cm$^2$ to $1 \times 10^{14}$/cm$^2$ and energy between 5KeV and 2 MeV. LDD implants, which are common in high performance CMOS technology, may be used advantageously to provide the lower doping density required by the polysilicon diode.

In yet another example use is made of Schottky diodes. The Schottky diodes are formed at the interface of a layer of a metallic material, for example, titanium nitride, and n-type or p-type silicon. The Schottky diodes can be formed on n-type and p-type silicon by carefully selecting the work function of the metallic layer and adjusting the Fermi level of the silicon by control of doping. The voltage across the diodes can be adjusted by changing the doping in the well and the diode area.

Fig. 4E shows an exemplary and non-limiting cross section of a circuit 200 using a Schottky diode control circuit $Z_C$. Taking advantage of the suitable band gap of, for example, TiN as the contact metal, Schottky diodes can be formed on both the n-type and p-type silicon with light doping (less than $1 \times 10^{17}$/cm$^3$). Thus, a Schottky diode for NMOS is formed by making, for example, a TiN to n-type diode in the n-well region. A Schottky diode to work with PMOS is formed in the p-well region adjoining the PMOS transistor.

In one embodiment of the disclosed invention, the well biasing scheme is used only for PMOS transistors that are built in a CMOS technology. The PMOS transistors are isolated as they are formed in the n-well regions, while NMOS transistors are formed in the p-well regions that are electrically connected to one another because they are formed over p-type silicon substrate as the starting substrate material.

To control the substrate voltage, one or more diode types can be used in a design by connecting them in series or parallel to obtain the appropriate voltage at the substrate, with appropriate temperature coefficient. Also, the threshold voltage control can be applied to either or NMOS or PMOS transistor, or to both transistors with appropriate diode types. The invention covers the three cases, namely dynamic control of threshold voltage for NMOS only, for PMOS only, or that of both NMOS and PMOS.

For the purpose of explanation, it is now assumed that the operating voltage $V_{DD}$ is 1.0V for a CMOS circuit. A CMOS buffer uses the NMOS transistor with the source-substrate diode area of Asn and the current-voltage characteristics are as follows:

$$V_f = V_t{}^* \ln(I_{diode}/I_{sn0})$$

Where $V_t$ is the thermal voltage, $I_{diode}$ is the current passing through the well-substrate diode, and $I_{sn0}$ is the well-substrate diode saturation current.

An external diode $D_{ex}$ is used as a control device $Z_C$ 260. The voltage across the external diode is given by

$$V_{f\_ex} = V_t{}^* \ln(I_{diode}/I_{ex0})$$

Where $I_{ex0}$ is the diode saturation current of the external diode. Because the two diodes are in series, the same current flows through the diodes. The sum of the voltages across the two devices is equal to

$$V_{DD}.V_{DD} = V_f + V_{f\_ex} = V_t{}^* \ln(I_{diode}/I_{sn0}) + V_t{}^* \ln(I_{diode}/I_{ex0})$$

Because $I_{sn0}$ is fixed by the NMOS transistor characteristics, the voltage across the external diode is varied by changing diode saturation current $I_{ex0}$ which is a product of the current density and the area. If the voltage drop across the two diodes is exactly equal, then the substrate voltage of the NMOS transistor is at 0.5V when the gate is at 1.0V. Reducing $I_{ex0}$ results in decreased voltage drop $V_f$ across the source-substrate diode and hence, threshold voltage of the NMOS transistor.

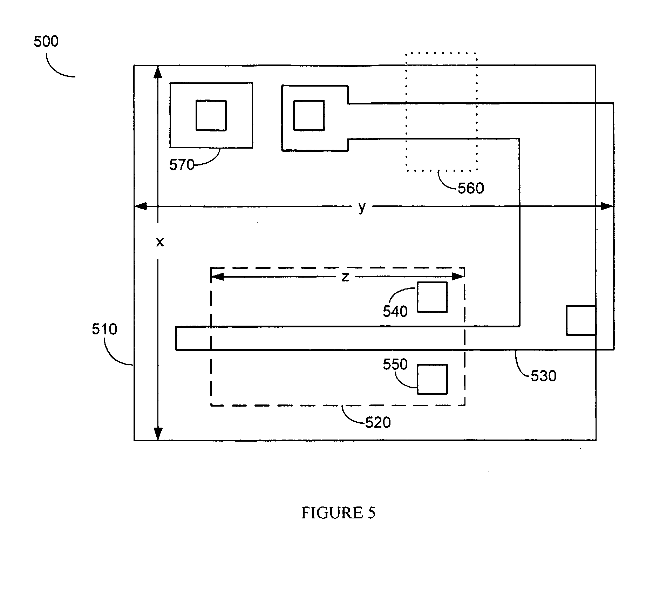

Fig. 5 shows an exemplary and non-limiting layout 500. of a layout of a MOS transistor with a control circuit $Z_C$. The MOS transistor is formed over a substrate 510, and further of a well 520, for example an n-well, over which a gate 530 is deposited having an insulating layer in between the well 520 and the gate 530. Contacts 540 and 550 are connected, for example, to the drain and source of the MOS transistor, and a contact 535 to the gate 530. Furthermore, a diode 560 is formed which may be connected to the substrate 570 by means of a metal path.

For a power supply voltage of 1.0V, the control circuit 280 complises a single diode. The diode should sustain a forward drop of between 0.5V to 0.6V when connected in series with the substrate-to-source diode. The resulting voltage drop across the substrate-to-source diode is 0.5 to 0.4V. In one example, the control circuit 260 is formed from a diffused diode. In an embodiment of the disclosed invention, the diode is formed from a single polysilicon diode or two polysilicon diodes connected in parallel. For a power supply voltage of 0.9V, the bias control circuit 260 provides a forward drop of no more than 0.4V across the substrate-to-source diode.

For a 1.2V power supply the resulting forward bias voltage on the substrate-to-source diode is 1.2V. The control circuit $Z_C$ 260 is comprised of a single poly-diode having a large voltage drop. The doping across the poly diode is controlled such that when the voltage at the gate terminal turns high, for example to 1.2V, the voltage drop across the polysilicon diode is nearly 0.7V and the drop across the source-substrate diode is 0.5V. This limits the leakage across the diode to less than 10 nano-amperes per micron width, i.e. nearly a ten-fold reduction in leakage. With the source-to-substrate bias at - 0.5V, the threshold voltage drops nearly 250 mV, resulting in an increase in the drain current of nearly 10 - 20% as compared to static threshold voltage.

In another embodiment of the disclosed invention, the benefits of the invention are accomplished by using a polysilicon diode in series with a Schottky diode formed by making TiN to n-type or p-type silicon.

In the case of a power supply of 1.5V, the NMOS and PMOS transistors have a threshold voltage of 0.45V, with an upper limit of 0.7V and a lower limit of 0.3V. These numbers refer to the magnitude of the voltage only because the threshold voltage of the PMOS devices is a negative quantity. The configuration of the control circuit $Z_C$ 260 depends upon the operating voltage. For a power supply voltage of 1.5V, the configuration of the control circuit $Z_C$ 260 is accomplished by using two diodes in series. The two diodes are made in polysilicon by doping the polysilicon with n+ and p+ implant and the using silicide to connect the gate of the NMOS transistor to the anode, or for a PMOS transistor to the cathode, of the first diode. Similarly, the cathode of the first diode is connected to the anode of the second diode with silicide. Because silicide is formed on the polysilicon layer in a self-aligned manner, it does not require any contact hole or metal to be formed on the transistor. The diodes can also be formed on a silicon substrate. Furthermore, a combination of diodes formed on polysilicon and silicon substrates can be used. In an implementation of disclosed invention in SOI technology, the diode is formed on isolated islands insulated by oxide or by a set of polysilicon, diodes, as described above.

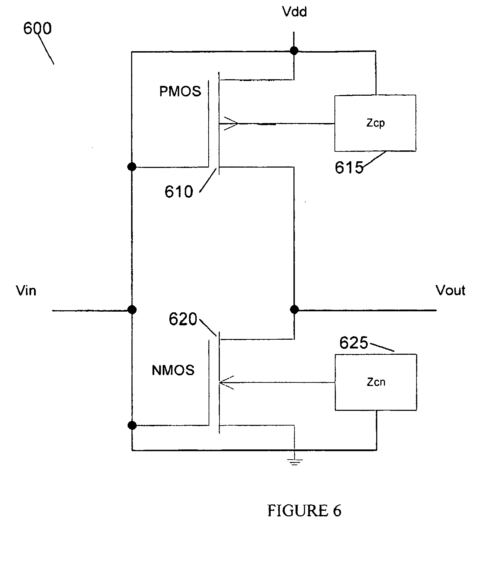

Fig. 6 is an exemplary and non-limiting schematic 600 of a CMOS buffer that is formed using the disclosed invention. Control circuits $Z_{Cn}$ 625 and $Z_{Cp}$ 615 are the active devices for controlling the threshold voltage of an NMOS transistor 620 and a PMOS transistor 610, respectively. The control circuits 615 and 625 are implemented in accordance with the disclosed invention.

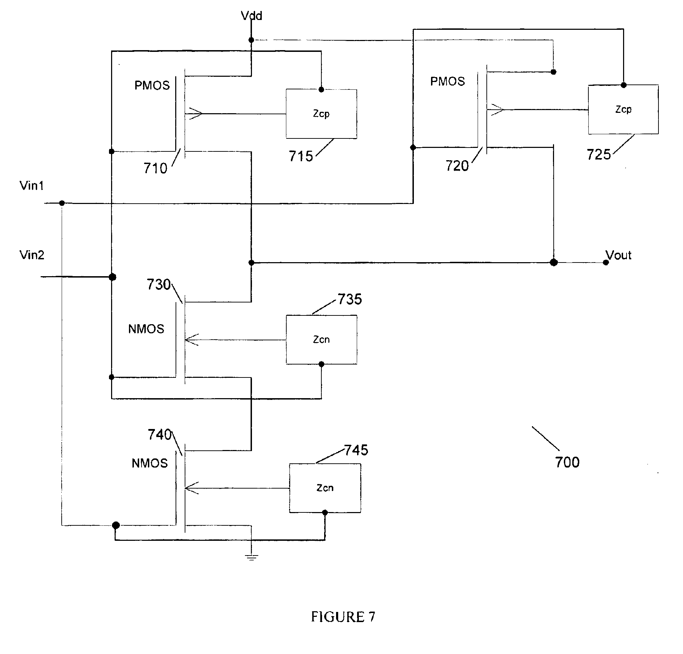

Fig. 7 shows an exemplary and non-limiting schematic 700 of a CMOS NAND gate that is formed using the disclosed invention. The two inputs to the NAND gate are $V_{in1}$ and $V_{in2}$, and $V_{out}$ shows the output of the circuit 700. The active circuits for controlling the threshold voltages of the NMOS transistors 730 and 740 are the control circuits $Z_{Cn}$ 735 and $Z_{Cn}$ 745, respectively. The active circuits for controlling the threshold voltages of PMOS transistors 710 and 720 are $Z_{Cp}$ 715 and $Z_{Cp}$ 725, respectively. The control circuit 715, 725, 735, and 745 may further be customized for different transistors, as may be required by specific circuit configurations. The control circuits 715, 725, 735, and 745 are implemented in accordance with the disclosed invention.

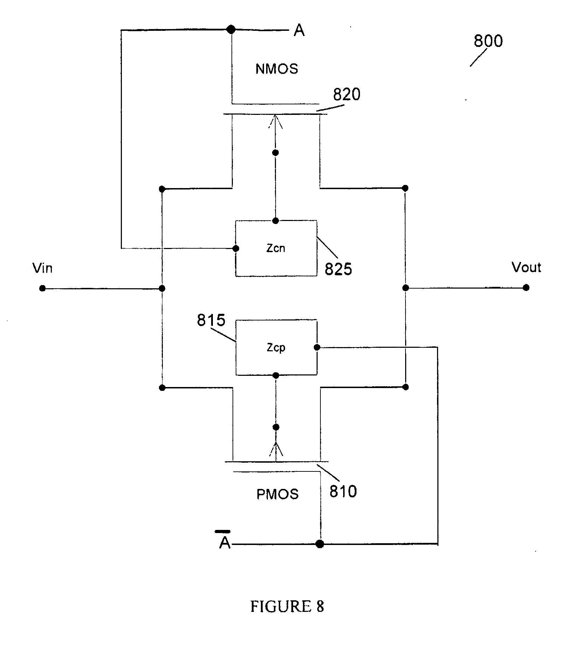

Fig. 8 is an exemplary and non-limiting schematic 800 of a CMOS pass gate with a signal A controlling the status of the pass gate. The threshold levels of the NMOS transistor 820 are controlled by the control circuit $Z_{Cn}$ 825. The threshold levels of the PMOS transistor 810 are controlled by the control circuit $Z_{Cn}$ 815. The pass gate may also comprise only an NMOS transistor, for example the NMOS transistor 820, or only a PMOS transistor, for example the PMOS transistor 810, with the corresponding active threshold control device, as deemed appropriate for the specific application. The control circuits 815 and 825 are implemented in accordance with the disclosed invention.

A person skilled in the art would note that while the description provided herein is for VDD voltages below 1.5V, the same apparatus and method can be implemented with appropriate modifications to VDD voltages higher than that. Furthermore, the descriptions herein are provided as mere examples of the disclosed invention and by no means should be viewed as limiting the scope of the disclosed invention. While NMOS implementations are shown herein, the invention can be equally used for PMOS transistors. Moreover, it is noticed that typically, in a representative deep submicron CMOS process using 0.1 micron lithography, the change in leakage current from 0V substrate bias to -1V substrate bias for a PMOS transistor is much higher (nearly a factor of 10), while the leakage current change from 0V to -1V substrate bias for an NMOS transistor is lower (a factor of 3 - 3.5). This is due to the fact that the well region of the PMOS transistor is highly doped to counter dope against the diffusion of P+ source and drain. By contrast, the N+ source and drain region of an NMOS transistor are rather well controlled and hence the substrate doping is kept rather low, which leads to minimal change in leakage with substrate bias. Hence, a process change which increases the substrate doping will cause the amplification of the effect of the substrate voltage manipulation. This is also supported by the basic principles of MOS device physics which dictates that the impact of substrate bias on threshold voltage is enhanced with increasing substrate doping. Notably, this also results in an increase in the capacitance of the source and drain region, however, it has a minimal impact upon the circuit speed since the load capacitance in deep submicron CMOS VLSI circuits consists mainly of interconnect capacitance. Therefore, the use of a more highly doped substrate or well region, results in the increase in drain current by forward biasing. Alternately, for the same drain current, the leakage current is decreased. The device characteristics can also be optimized to increase the bulk doping level as well as the gate oxide thickness, so that drain leakage and gate tunneling current is decreased simultaneously.

Using the structures described above, the disclosed invention provides a method and apparatus for improving the performance of various semiconductor memory types by dynamically managing the threshold voltage of certain critical transistors in respective memory cells. The disclosure herein concerns typical, but non-limiting, implementations of the invention in respect of static random access memory (SRAM) cells and dynamic random access memory (DRAM) cells. The invention is also applicable to other types of memories, such as multi-port SRAM, and non-volatile memories, such as EEPROM and flash memories.

Fig. 10 shows the construction of a SRAM cell with dynamic threshold control. The memory cell is formed by cross coupling of the PMOS transistors 1012 and 1014, and NMOS transistors 1022 and 1024. The pass transistors are marked as 1026 and 1028. The PMOS transistors are formed in n-well 1032 that is shared by a number of PMOS transistors in memory cells placed in a row. This is similar to the arrangement of conventional CMOS memory cells. The power to the memory cell is supplied by the power bus 1042, and the common ground connection is provided by a metal line 1044, both of which run horizontally, as shown in Figure 10. The data read and write is provided by metal lines 1044 and 1048.

The additional apparatus enabling the invention is described by a common p-well 1050 shared by the NMOS transistors in the cell and by multiplicity of adjacent memory cells in the same row. The NMOS transistors are normally formed in the p-type substrate and share the substrate connection with all other transistors in the chip. Implementation of the dynamic threshold voltage control scheme requires that the NMOS transistors be isolated from other transistor (s) and the substrate. This is achieved in a triple well CMOS process, as is known to those skilled in the art. An alternate embodiment of this feature is achieved by using a method as described herein below. The p-well is used to isolate the memory cells from the rest of the substrate. This invention uses a varying number of memory cells sharing the p-well. The only restriction placed upon the formation of the p-well is that they should be electrically connected. The isolation of p-well is accomplished by placing an n-type layer between the substrate and the NMOS transistors. This n-type layer is formed by any of the conventional means of forming a deep layer of opposite polarity in a silicon chip. An example of such a process step is the formation of an n-layer by deep ion-implant in silicon in the area where NMOS transistors are formed. The ion-implant energy and dose depend upon the remaining process steps used to form the transistor. The n-layer can be formed by ion-implant of atoms of phosphorous at energy of 200 KeV to 5 MeV with the implant dose of $1 \times 10^{11}$ atoms/cm$^2$ to $1 \times 10^{14}$ atoms/cm$^2$.

The invention uses a substrate biasing apparatus 1030 for dynamic threshold control, connected from a word line 1040 to a p-well 1050. This apparatus actively manages the threshold voltage of the NMOS transistors in the p-well, such that the threshold voltage is high when the word line is at zero volts. An advantage of a high threshold voltage of MOS transistor is that it results in low drain-source leakage when there is zero voltage at the gate, and it leads to greater stability of the memory cell. A disadvantage of the high threshold voltage is that the drain current conducted by the transistor is reduced when the transistor is ON. This limitation is reduced, as taught herein, by using an active biasing circuit 1030 for controlling the bias at the p-well 1050, such that when the voltage on the word line is raised to $V_{DD}$, or is raised high, the voltage at the p-well is also raised without conducting a significant amount of current from the power source. The raising of the voltage at the p-well results in lowering of the threshold voltage of the NMOS transistors in the well. This results in a higher current conducted by the transistors, which results in faster read and write operation of the memory cell. Thus, by using the disclosed dynamic biasing scheme for the memory cell, circuit operation is made more stable and it is also made faster. By sharing the active device for the dynamic control of the threshold voltage between multiple memory cells, the area impact of adding this new threshold voltage control component on the memory cell size is minimized.

As noted above it may be desirable to achieve a large body effect, especially with the application of positive voltage to the substrate region of a NMOS transistor, and a negative voltage to the well region of a PMOS transistor. This is desirable from the standpoint of the disclosed invention because it allows the changes in threshold voltage to be magnified upon application of positive (negative) bias to the substrate (well). To enhance the body effect in the transistors further, a super steep retrograde profile is achieved by suitable process steps, which results in a very rapidly increasing dopant concentration at a certain depth from the surface. To achieve greater reduction in leakage current between the source and drain, as described herein, the super steep retrograde well profile is implemented, where the substrate doping is increased from the low surface doping to a high well doping ranging between $10^{18}$ and $10^{19}$ atoms/cm$^3$ within a depth range of 0.1 micron to 1 micron. This high doping profile results in a very rapidly varying threshold voltage of the MOS transistor upon application of bias on the substrate of the transistor. This property of the MOS transistor is also referred to as very high body effects.

The active device, used for the dynamic control of threshold voltage may be a series of diodes, as shown above. The exact number of diodes used in a certain instance depends upon the voltage levels deployed in the circuit. For example, circuits using voltage level between zero and $V_{DD}$, where $V_{DD}$ ranges between 0.7 V and 1.4 V can implement the invention by using a single diode between the word line and the p-well. Implementation of the invention with all its benefits for systems using voltage levels of up to 1.8V may require the use of two diodes in series. The diodes are formed in complete isolation from both the n-well and the p-well. In an example diodes are formed by laterally doped regions of polysilicon on oxide, which is naturally isolated.

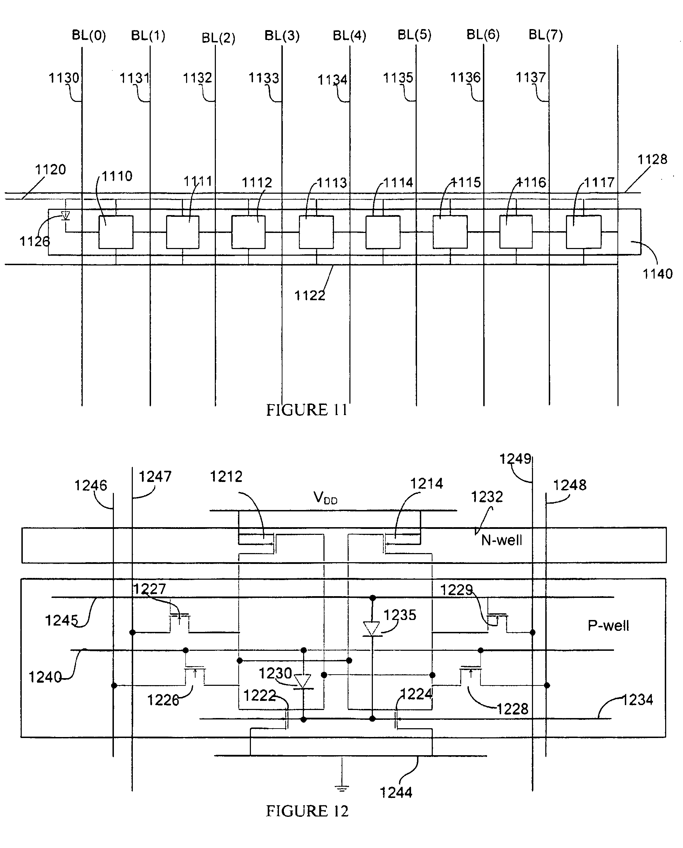

Figure 11 is an exemplary, but not limiting, representation of the disclosed invention, where eight memory cells marked 1110 to 1117 are formed in a region which has a common p-well region 1140. It is not necessary for the implementation of the invention to force the n-wells to implement similar schematic. N-wells can contain lesser or greater number of PMOS transistors, as may be determined by other design constrains known to those skilled in the art. The bit lines connecting the cells are lines 1130 through 1137. The word line is line 1120. For ease of demonstration, the power bus is not shown in Figure 11. The ground line is line 1122. The dynamic biasing of the p-well is implemented by threshold control devices 1126, as described in connection with Figure 2, by connecting the word line and p-well region 1140.

Figure 12 shows an exemplary and non-limiting implementation of the disclosed invention for a dual-port SRAM. While a dual-port implementation is described a person skilled in the art could easily extend this implementation to a multi-port implementation. Because there are two word lines 1240 and 1245 used, it is necessary to connect two corresponding threshold control circuits 1230 and 1235 respectively, the circuits further being connected to a common substrate 1234. The operation of each word-line itself is identical to the description herein above.

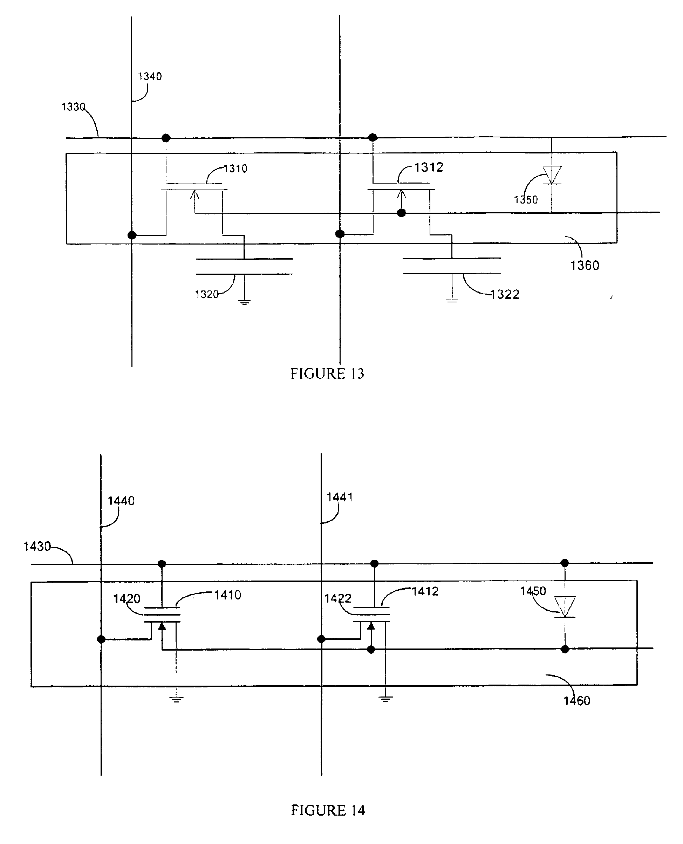

Figure 13 shows an exemplary and non-limiting implementation of the disclosed invention for a array of DRAM cells. The DRAM consists of an array of pass transistors, e.g. 1310 and 1312, connected to corresponding storage capacitors. Pass transistors 1310 and 1312 are further connected to storage capacitors 1320 and 1322, respectively. The row of pass transistors is addressed by a word line 1330. As the word line voltage is raised, the pass transistors 1310 and 1312 are turned on. The charge on the capacitor is read by the active bit line, e.g. the bit line 1340. The intersection of bit line 1340 and word line 1330 uniquely identifies the charge storage capacitor, e.g. the storage capacitor 1320.

The functioning of DRAM is well known to those skilled in the art. With scaling down of the gate length, the pass transistors 1310 and 1312 suffer from the limitations described above. The operation of the DRAM cell depends, to a certain extent, upon the rate at which data are read from the capacitor, e.g. the storage capacitor 1320, and it is written in the capacitor through the pass transistor. The leakage across the drain to source junctions of the pass transistor has to be kept extremely low, on the order of picoamperes, to prevent the charge in the cell from leaking through the pass transistor and causing an error. The DRAM is characterized by regular refresh cycles that are used to refresh the data in the cell because the charge is lost by recombination over time. Leakage of the pass transistor can add another mechanism for the loss of data from the storage capacitor that is likely to increase the need for refresh, or reduce the refresh cycle. This results in less time available for reading or writing to the memory cell.

In accordance with the disclosed invention there is shown a method to maintain the leakage of the pass transistor, e.g. the pass transistors 1310 and 1312, at a low level and increase the drive strength of the pass transistor simultaneously to speed up the reading and writing of data in the memory cell without sacrificing the stability of the cell. This is achieved by using a dynamic threshold voltage control. This accomplished by designing all the pass transistors in a row in an isolated p-well, separated from the substrate by an n-region. The pass transistors addressed by a word line are placed in the same p-type isolation area. A dynamic biasing element 1350 is connected between the word line and the isolation p-well, such that when the word line voltage is increased a fraction of the voltage from the word line is made incident upon the p-well. The voltage of the p-well is kept well below the turn on voltage of the p-substrate to n-source diode of the MOS transistor, and the rise time of this voltage is kept to a minimum by using the active biasing element. For a DRAM built with deep submicron technology on the order of 0.15 micron or below, and operating at voltages equal to or below 1.5V, the active biasing element for the p-well may comprise a bank of diodes connected in series. Multiple diodes are connected in series to restrict the voltage at the p-substrate at 0.5 V, and allow the rest of the voltage drop to take place across the active biasing diodes. As the operating voltage is brought to at or below a voltage ranging between 0.7 and1.4 V, a single diode can be used to implement the dynamic biasing scheme. The use of diode ensures a very efficient means of actively changing the biasing voltage of the p-well region containing the NMOS transistors.

The schemes disclosed herein are further applicable to other forms of memory cells, such as flash memory, electrically programmable read only memory (EPROM) and electrically erasable programmable read only memory (EEPROM), amongst others. In each of these memory types, the condition of a memory cell is detected by selectively turning on a pass transistor. The operation of these memory types is made more efficient and faster by use of the method of dynamic biasing of the substrate disclosed herein. In each of these cases, the biasing element used for implementing this scheme comprises a series of diodes, dynamically controlling the ON and OFF threshold values, the biasing element being shared by a number of memory cells. This ensures that the additional area needed for implementing the dynamic threshold control is kept to a desirable minimum.

Figure 14 shows an exemplary and non-limiting implementation of the disclosed invention for an array of non-volatile memory (NVM) cells. The NVM consists of an array of storage transistors, e.g. 1410 and 1412, with floating gates 1420 and 1422, respectively. The row transistors are addressed by a word line 1430. As the word line voltage is raised, transistors with charge stored on the floating gates 1410 and 1412 are turned on. The current through the transistor is read by the active bit line, e.g. the bit line 1440. The intersection of the bit line 1440 and the word line 1430 uniquely identifies the storage transistor, e.g. the transistor 1410 with a floating gate 1420. The functioning of NVM is well known to those skilled in the art. With scaling down of the gate length, the pass transistors 1410 and 1412 suffer from the limitations described above. The operation of the NVM cell depends, to a certain extent, upon the rate at which data are read from the transistor 1410. The writing of data on the floating gate uses other programming methods. The read speed of NVM cell is extremely important in determining the speed of operation of the memory. As well, the leakage of the transistor is extremely important because these devices are used in battery operated applications in many instances, and the transistor leakage can result in rapid discharging of the battery.

In accordance with the disclosed invention there is shown a method to maintain the leakage of the NVM transistors 1410 and 1412 at a low level, and to increase the drive strength of the transistor simultaneously to speed up the reading of data from the memory cell without causing excessive leakage of the memory cell. This is achieved by using a dynamic threshold voltage control, where all the transistors in a row in an isolated p-well are separated from the substrate by an n-region. The transistors addressed by a word line are placed in the same p-type isolation area. A dynamic biasing element 1450 is connected between the word line and the isolation p-well, such that when the word line voltage is increased, a fraction of the voltage from the word line is made incident upon the p well. The voltage of the p-well is kept well below the turn on voltage of the p-substrate to n-source diode of the MOS transistor, and the rise time of this voltage is kept to a minimum by using the active biasing element. For an NVM built using deep submicron technology of the order of 0.15 micron or below, and operating at voltages equal to or below 1.5V, the active biasing element for the p-well may comprise a bank of diodes connected in series. Multiple diodes are connected in series to restrict the voltage at the p-substrate at 0.5 V, and to allow the rest of the voltage drop to take place across the active biasing diodes. As the operating voltage is brought to at or below a voltage ranging between 0.7 and 1.4 V, a single diode can be used to implement the dynamic biasing scheme. The use of a diode ensures a very efficient means of actively changing the biasing voltage of the p-well region containing the NMOS transistors.

A person skilled-in-the-art would have noticed that typically, in a representative deep submicron CMOS process using 100 nanometer lithography, there is almost a factor of ten change in leakage current from 0V substrate bias to -1V substrate bias for a PMOS transistor, while there is only a factor of 3-3.5 change in leakage current from 0V to -1V substrate bias for an NMOS transistor. This is due to the fact that the well region of the PMOS transistor is highly doped to counter dope against the diffusion of P+ source and drain. By contrast, the N+ source and drain region of an NMOS transistor are well controlled and, hence, the substrate doping is kept low, which leads to minimal change in leakage with substrate bias. A process change which increase the substrate doping causes the amplification of the effect of the substrate voltage manipulation. Notably, this also results in an increase in the capacitance of the source and drain region.

However, this has a minimal impact upon the circuit speed because the load capacitance in a deep submicron CMOS VLSI circuit consists mainly of interconnect capacitance. Therefore, the use of a more highly doped substrate or well region, results in the increase in drain current by forward biasing. Alternately, for the same drain current, the leakage current is decreased. The device characteristics can also be optimized to increase the bulk doping level as well as the gate oxide thickness, so that drain leakage and gate tunneling current is decreased simultaneously.

Another embodiment of the disclosed invention comprises a simple to implement apparatus and method for the reduction of gate leakage of deep sub-micron metal oxide semiconductor (MOS) transistors, especially those used in a cross coupled static random access memory (SRAM) cell. The invention is further applicable in other circuits where the gate leakage reduction is desirable or required. In accordance with the invention, the active element of the SRAM cell is used to reduce the voltage on the gate of its corresponding transistor without impacting the overall switching speed of the circuit. Because the load on the output of the inverter is fixed, a reduction in the gate current is optimized to minimize the impact on the switching waveform of the memory cell. An active element formed by two materials with different Fermi potentials is used as a rectifying junction, essentially performing a diode function. The rectifying junction also has a large parallel leakage path, which allows a finite current flow when a signal of opposite polarity is applied across the device.

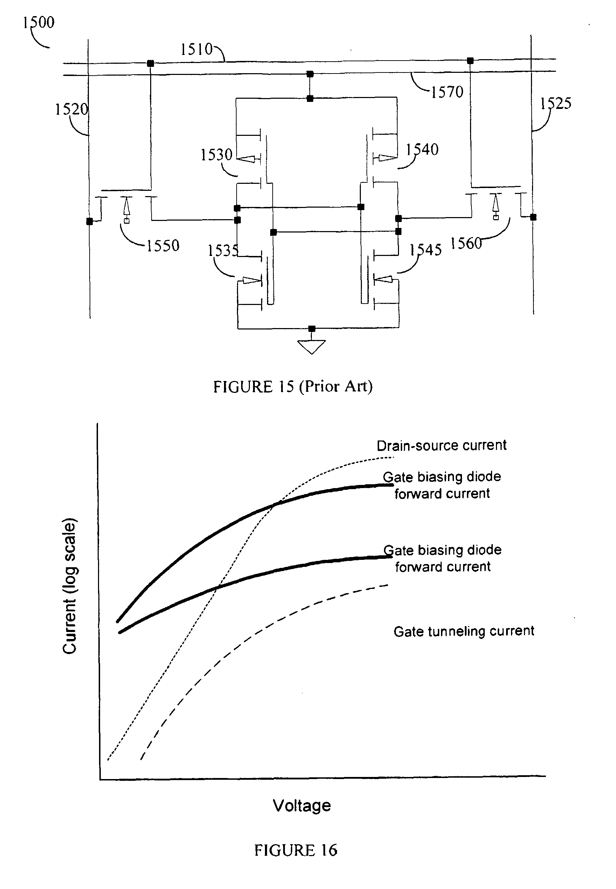

In the case of an SRAM cell, two complementary MOS (CMOS) inverters are cross-coupled, and the load on the inverter is a single transistor which is used for accessing the inverter. A typical prior-art circuit 1500 configuration used for an SRAM is shown in Fig. 15. The basic cell is comprised of two cross-coupled inverters, formed of transistors 1530 and 1535, and 1540 and 1545, respectively. Pass transistors 1550 and 1560 are used for accessing the inverters. By controlling the voltages on the gates of the pass transistors 1550 and 1560 by means of word line 1510, it is possible to provide the data and its inverted value on the bit lines 1520 and 1525, respectively, or to read the data using the same bit lines. A person skilled-in-the-art would appreciate that in this circuit the load on transistors 1530, 1535, 1540, 1545, 1550, and 1560 is well defined in all instances of the design, a fact which is to be exploited to reduce the gate leakage in accordance with the principles of the disclosed invention.

Another example takes advantage of this property of the memory cell by using an active element to reduce the voltage on the gate of a transistor of the inverter, for example transistor 1535, without impacting the switching speed of the circuit. An active element is formed by two materials having different Fermi potentials and is used as a rectifying junction or a diode. The rectifying junction also has a large parallel leakage path, which allows a finite current flow when a signal of opposite polarity is applied across this device. Exemplary, but not limiting embodiments of this rectifying junction include diodes made with N+ and P+ polysilicon with large leakage across the junction, a rectifying contact with a metal layer and an N type polysilicon layer, or a P type polysilicon layer and a metal layer of appropriate ionization potential with a significant leakage through the junction. In accordance with an exemplary embodiment there is shown, without limitation, a use of junctions with leakage current between 1 nA/$\mu$m2 and 1 mA/$\mu$m2 with 1 V bias across the junction. An exemplary and non-limiting graph of the pseudo-rectifying characteristics of a diode configured in accordance with the invention is shown in Fig. 16.

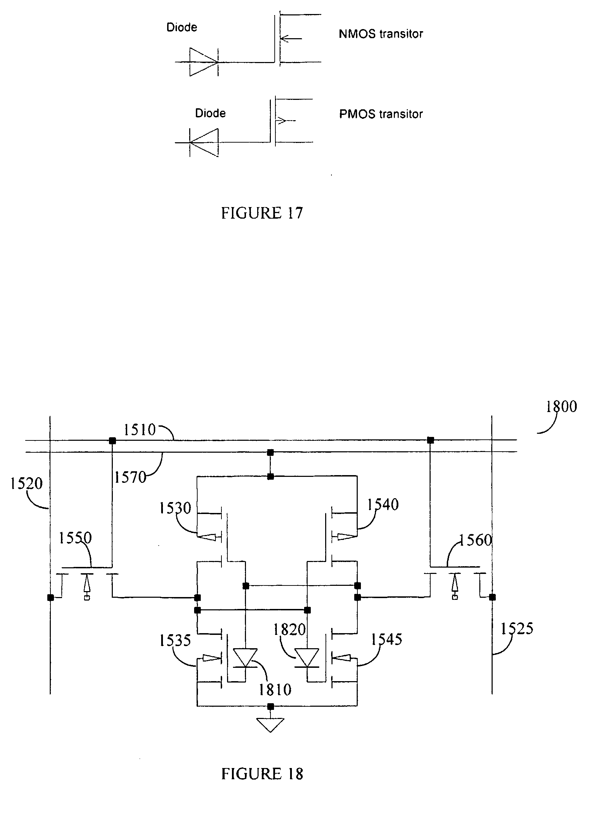

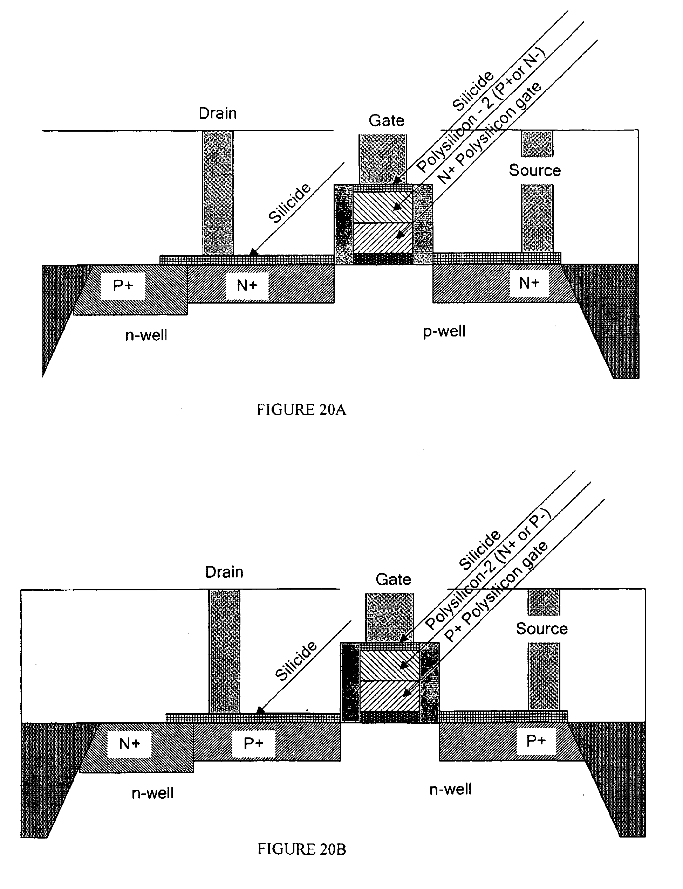

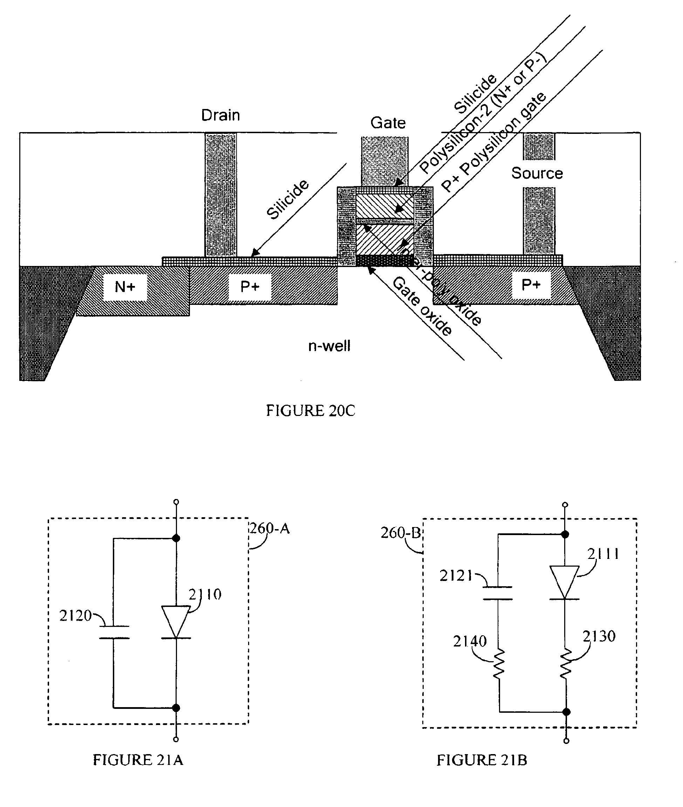

Reference is now made to Fig. 17 which shows an exemplary configuration of a NMOS transistor and a PMOS transistor, each with the diode connected to its respective gate. The diodes are designed to have a very low forward drop (preferably less than 0.5 V) and a very high reverse current (preferably greater than 1.0 mA/cm2). The diodes are connected in series with the gate of the respective transistor, in a direction depending on the type of the transistor. Specifically, for a NMOS transistor, the cathode of the diode is connected to the respective gate; for a PMOS transistor, the anode of the transistor is connected to the respective gate. As the transistor gate voltage increases, a fraction of the incident voltage drops across the diode and the rest drops across the gate-source junction of the respective transistor. This reduces the voltage at the gate of the respective transistor which, in turn, reduces the gate tunneling current. Referring to Figs. 20A-20C, there are shown cross sections of NMOS (Fig. 20A) and PMOS (Fig. 20B) transistors with diodes manufactured in accordance with an exemplary implementation . A P-N diode or a Schottky diode may be created on the gate. In one example (Fig. 20C) a leaky oxide may be used as a leakage reduction mechanism.

Referring now to Fig. 18, there is shown an exemplary and non-limiting SRAM cell with diodes connected to the gate of the NMOS transistors. Diodes 1810 and 1820 are connected to the gates of NMOS transistors 1535 and 1545, respectively. In accordance with an alternate example, a similar arrangement (not shown) with diodes connected to the gates of PMOS transistors 1530 and 1535 is provided. In yet another example, diodes are connected with the gate of NMOS transistors 1535 and 1545 and PMOS transistors 1530 and 1540. These exemplary embodiments should be considered as mere illustrations of the possibilities of connecting the diodes to the gates of the transistors of the inverters of SRAM cell 1800, and any other possible combination of the diodes connected to the transistors is specifically included. A person skilled-in-the-art would readily recognize the advantages where the two inverters are connected in a feedback circuit. This arrangement and the circuit elements allow the operation of the SRAM cell with minimal impact of the operation of the circuit. Reduction in the gate voltage also results in reduced gate tunneling current.

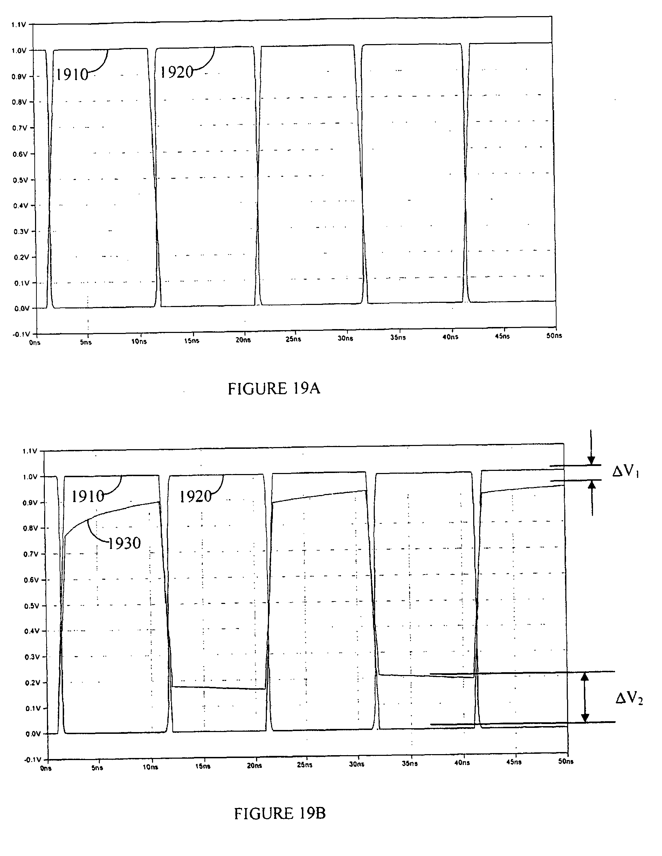

Reference is now made to Figs. 19A and 19B where a voltage waveform of SRAM cells 1500 and 1800, respectively, is shown. The waveforms shown in Figs 19A and 19B are of simulation of the basic inverters formed by transistors 1535 and 1545. A pulse generator drives this circuit, and the output is measured at the common drain of transistors 1535 and 1545 as signals 1910 and 1920, respectively. Figure 19B shows a voltage waveform at the input and output of a CMOS inverter with diode coupled gate. The voltage waveform at the gate of the NMOS transistor shows a reduced voltage swing. The drop in voltage across the diode is marked in the figure as $\Delta V$.

The diode, for example diode 1810, that is coupled to a gate of a transistor, for example transistor 1535, may be realized by, but is not limited to, any one of the following implementations:

(a) A layer of P+ polysilicon on top of N+ polysilicon, which forms the gate of the transistor to realize a P-N diode in polysilicon for NMOS;

(b) A similar structure with polarities reversed to realize a diode in series with a PMOS gate;

(c) A Schottky diode realized by metal - N-type polysilicon on top of N+ gate polysilicon for NMOS transistors;

(d) A Schottky diode realized by metal - P-type polysilicon on top of P+ gate polysilicon for PMOS transistors;

(e) A lateral N+ to P+ polysilicon diode, as described in further detail elsewhere; or

(f) An MOS capacitor formed with the layers of salicide and gate polysilicon layers as the electrodes and a thin layer of oxide as the dielectric the conduction through which takes place by a tunneling effect.

While the application of the invention is described herein primarily in reference to a SRAM cell, this is done as an example of the invention, and further due to the fact that this circuit configuration is one of the most common building blocks in very large scale integration (VLSI) circuits and it presents a fixed load for the transistors. The invention is not limited to the exemplary application and other uses are to be considered an integral part of the invention.

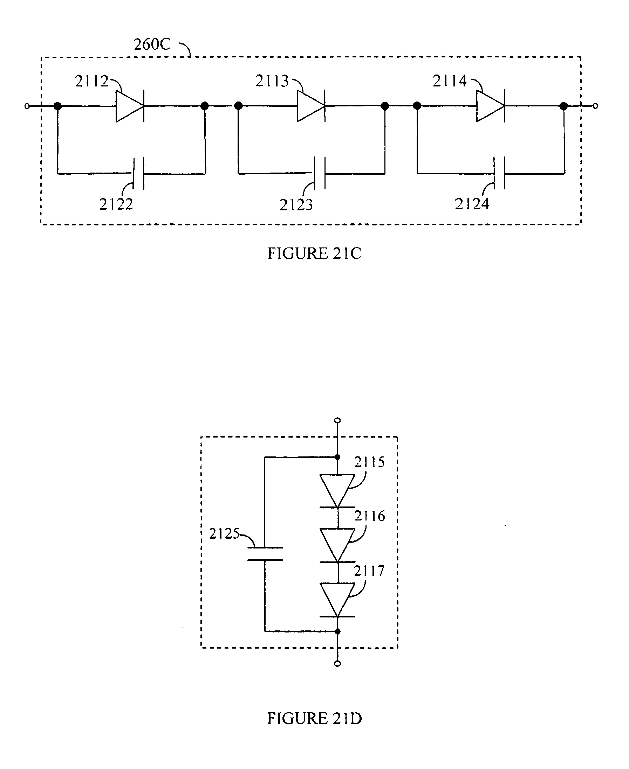

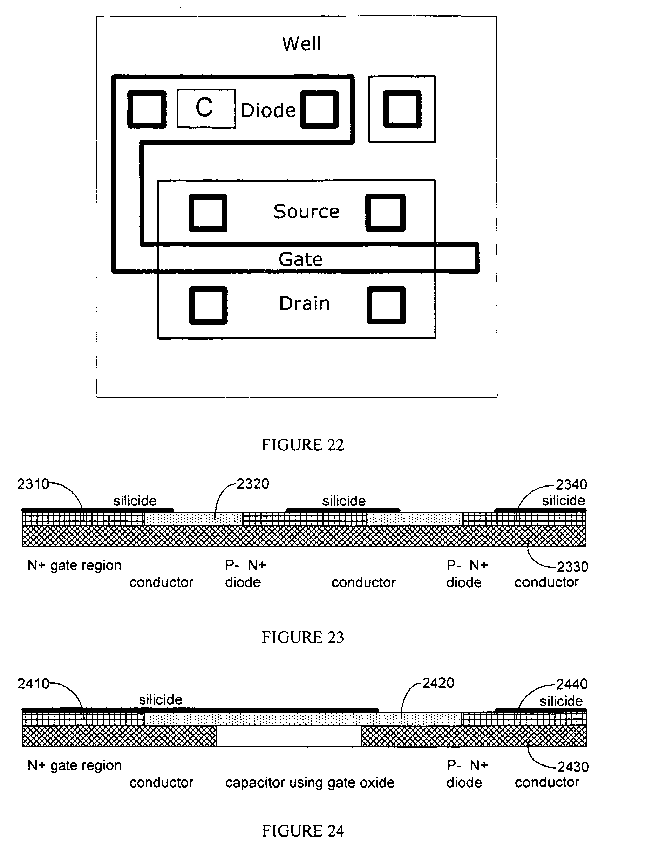

Reference is now made to Fig. 21 where a plurality of configurations of control circuit $Z_C$ 260 are shown. The circuits can equally apply for use with both PMOS and NMOS transistors. Specifically, the circuits shown in Figs. 21A-21 D include in addition to at least a diode, as described in more detail above, at least a capacitor. The use of a capacitor in parallel to a diode, in a circuit $Z_C$ according to the disclosed invention, enables the waveform at the well terminal to be controlled. In the absence of the capacitor, the transient waveform of the well may be the subject of significant influence of the transient voltage at the output terminal, resulting in anomalous increase in leakage current under transient conditions. Therefore the capacitor allows the well voltage to track the input voltage more accurately under transient conditions. Tracking help is needed because the tiny currents of the diodes do not move the well voltage quickly enough to allow full drive current for short pulses. In addition the counteracting of the Miller effect is also a factor in the use and determination of the value of such a capacitor. Hence, in one embodiment of the disclosed invention it would be advantageous to incorporate a capacitor connected in parallel to the diode as part of control circuit $Z_C$ 260. In Fig. 21A there is shown an exemplary and non-limiting control circuit 260A where a capacitor 2120 is connected in parallel with a single diode 2110. An exemplary and non-limiting circuit layout that includes a MOS transistor in combination with control circuit 260A is shown in Fig. 22. In Fig. 21 B there is shown an exemplary and non-limiting control circuit 260B where a diode 2111 is in series with a resistor 2130 and a capacitor 2121 is in series with a resistor 2140. In Fig. 21C there is shown an exemplary and non-limiting control circuit 260C where a plurality of diodes, for example diodes 2112, 2113, and 2114, is each connected to a parallel capacitor, for example capacitors 2122, 2123, and 2124, respectively. It should be noted that the actual number of diodes is determined by the exact circuit application. Yet another configuration employing multiple diodes is shown in the exemplary and non-limiting Fig. 21 D, where a single capacitor 2125 is shown in parallel with a plurality of diodes, for example diodes 2115, 2116 and 2117. It should be noted that each of these diodes and capacitors may be replaced by the same circuit element in series with a resistor, as shown, for example, with respect to Fig. 21 B above. Inventors further note that any combination of these circuit elements in series and/or parallel can also be used for optimum circuit performance, and are specifically part of the disclosed invention. This is shown in figure 21 D.

The preferred value of the capacitor to implement for the control of the voltage waveform is related to the capacitance of the gate oxide. This capacitance value ranges between 0.01 to 100 times the value of the gate capacitance. The most important factor in designing the feed-forward capacitor is the total capacitance of the well to other portions of the device. That capacitance is typically similar in magnitude to the gate capacitance. Ideally, the capacitance voltage division will be identical to the voltage division established by the diodes. In another embodiment of the disclosed invention performance reasons may cause a deviation from that standard. Multiple methods can be used to realize this capacitance. The resistors and capacitors shown in Fig. 21 can be realized by many different methods. Fig. 22 shows the implementation of the control circuit with a capacitor in parallel to the diodes, where the capacitor is formed in the region marked C between polysilicon and an underlying thin oxide layer on top of the well region which is electrically connected to the body of the NMOS transistor. It should be noted that in a preferred embodiment capacitor from p+ poly over a p-well and n+ poly over an n-well is preferred over a capacitor formed of n+ poly over p-well and so on. The former styles are much less likely to form inversion layers, which would reduce the dynamic capacitance. In an alternate embodiment, this capacitor is constructed using a metal-insulator-metal (MIM) implementation, known to those skilled in the art. These capacitors are formed by introducing a thing layer of oxide between two layers of metal. In yet another embodiment metal-oxide-metal (MoM) capacitor is used, which is formed by the fringing capacitance between inter-digitated metal fingers. The metal capacitors discussed herein have the advantage of not being in the same plane as other components of the circuit, and therefore do not contribute materially to the layout area.

Reference is now made to Figs. 23 and 24 where exemplary and non-limiting implementations of lateral poly diodes are shown. These diodes may be used to form the control circuits discussed hereinabove. The formation of the diodes is discussed in detail in "A 2 Micron High Performance Bipolar 64K ECL Static RAM Technology With 200 Square Microns Contactless Memory Cell", IEDM Technical Digest 1984, pp. 690-693, by Vora et al. included herein by reference for all that it contains. Fig. 23 shows a pair of p- to n+ diodes as exemplary deployed as part of the Zc network 260 for an NMOS transistor. The green 2310 is n+ poly, pink 2320 is p- poly and the blue 2330 is field oxide. Fig. 23 shows a similar structure for a capacitor and one lateral poly diode where the green 2310 is n+ poly, pink 2320 is p- poly and the blue 2330 is field oxide. In both cases, the contact to the relevant p-well is made from point 2340 or 2440 respectively.

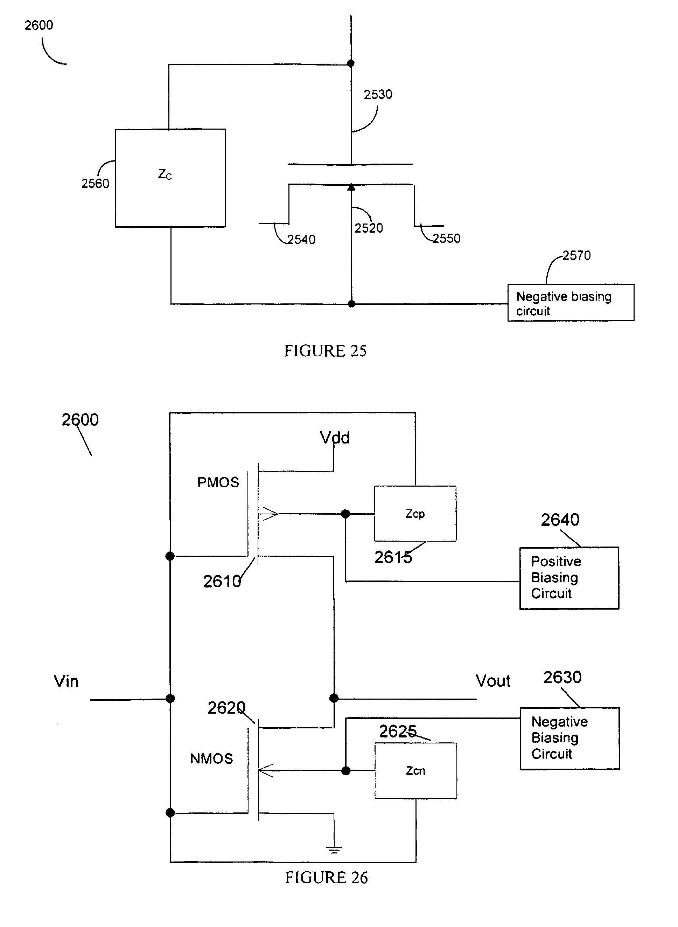

With reference to Fig. 25 there is shown an exemplary and non-limiting implementation of an embodiment of the disclosed invention with additional circuit to implement negative bias on the p-well of an NMOS transistor. The elements 2520 through 2560 have the description of elements 220 through 260 of Fig. 2 respectively. In addition a negative bias control 2570 is configured to provide a negative bias to well 2520. The negative bias further reduces the threshold voltage of the NMOS transistor. The impact of applying negative bias on the threshold voltage of NMOS is well documented in text book of MOS transistors and known to those skilled in the art. Equivalently, for PMOS transistors, a positive bias is applied to increase the magnitude of its threshold voltage. The bias discussed herein is applied in such a manner that it does not interfere with the operation of the invention disclosed herein. In an exemplary and non-limiting embodiment of the invention, bias circuit 2570 is activated when there is no activity on the input 2530 of the MOS transistor. During the period when the input voltage at gate 2530 is expected to be varied, the negative biasing circuitry is disconnected from well 2520 by means of negative bias control 2570.

Fig. 26 shows an exemplary and non-limiting embodiment of well biasing as it applies to a CMOS inverter. The various elements numbered 2600 through 2625 have the same description and function as elements 600 through 625 respectively of Fig. 6. Bias controls 2630 and 2640 are circuit elements configure to enable a negative voltage and a positive voltage to the wells of the NMOS and PMOS transistors respectively when the input of the transistors are inactive. A person skilled in the art would readily realize that this configuration may be extended to other circuits without departing from the spirit of the invention and such circuits are hereby specifically included.

A person skilled-in-the-art would further notice that in the case where two or more of the same type MOS gates, for example n-channel gates, may be connected in series, e.g., NAND gate, that in such a cases leakage current from the MOS gates in series is significantly reduced. Similarly, in circuits where two or more p-channel gates may be connected in series, e.g. NOR gates, in such a cases leakage current from the MOS gates in series is significantly reduced. Therefore, in such cases, it may not be necessary to configure those MOS gates connected in series with the control circuit $Z_c$. However, for two or more MOS gates connected in parallel having such a control circuit $Z_c$ for each of the MOS gates will reduce their leakage current as taught by the disclosed invention. In one embodiment of the disclosed invention the MOS gates connected in parallel further share a common isolated well, i.e., P-well for n-channel devices and N-well for p-channel devices, and a single control circuit $Z_c$.

Although the invention is described herein with reference to the preferred embodiments, one skilled in the art will readily appreciate that other applications may be substituted for those set forth herein without departing from the scope of the present invention. Accordingly, the invention should only be limited by the Claims included below.

## Claims

1. An apparatus (200) comprising a metal-oxide-semiconductor MOS transistor having a source terminal (240), a drain terminal (250), a gate terminal (230), and a well terminal (220), and having a control circuit (260) connected between said gate terminal and said well terminal of said MOS transistor,
said control circuit (260) comprising a polysilicon junction diode (265-1) , said polysilicon junction diode (265-1) forward biases said well terminal (220) in the ON state of said MOS transistor;
said control circuit (260) effecting a first threshold voltage in said MOS transistor when said MOS transistor is in an OFF state and a second threshold voltage in said MOS transistor when said MOS transistor is in an ON state, wherein said first threshold voltage is higher in absolute value than said second threshold voltage; said apparatus (200) **characterized by**:

said polysilicon junction diode being in an isolated structure formed in a separate diffusion area from said MOS transitor,

2. The apparatus (200) of Claim 1, wherein said MOS transistor comprises any of:

   an n-channel device (620) and a p-channel device (610).

3. The apparatus (200) of Claim 1, wherein said control circuit (260) comprises:

   one or more forward biased junction diodes (265-N) connected in series with said forward biased junction diode.

4. The apparatus (200) of Claim 1, wherein said polysilicon diode is comprised of a uniform implant and an opposite heavy implant.

5. The apparatus (200) of Claim 1, wherein the substrate doping of said MOS transistor is optimized to reduce said leakage current.

6. The apparatus (200) of Claim 1, further **characterized by**:

   a substrate for said MOS transistor doped to a level optimizing said leakage current.

7. The apparatus of Claim 1, wherein said control circuit further comprises at least a capacitor (2120) formed to have a first terminal connected to said gate terminal (230) and a second terminal connected to said well terminal (220).

8. A method for reducing leakage current and increasing drive current in a metal-oxide semiconductor (MOS) transistor formed over a well (520) having a source terminal (240), a drain terminal (250), a gate terminal (230), and a well terminal (220), said method **characterized by** the steps of:

   forming in an isolated structure formed in a separate diffusion area from said MOS transistor at least one polysilicon diode (265-1) connected between said gate terminal (230) and said well terminal (220) of said MOS transistor to forward bias said well terminal (230) in the ON state of said MOS transistor;
   wherein a control circuit (260) is provided, said control circuit (260) comprised of the at least one forward biased diode (265), said method further comprising the steps of:

      operating said control circuit (260) to cause said MOS transistor to have a first threshold voltage in a transistor OFF state; and
      operating said control circuit (260) to cause said MOS transistor to have a second threshold voltage in a transistor ON state;
      wherein said first threshold voltage is higher in absolute value than said second threshold voltage.

9. The method of Claim 8, said MOS transistor comprising any of:

   an n-channel device (620) and a p-channel device (610).

10. The method of Claim 8, wherein formation of said polysilicon diode comprises the steps of:

    forming a uniform implant; and
    forming an opposite heavy implant.

11. The method of Claim 8, further comprising the step of:

    doping the substrate of said NMOS transistor to a level optimized for the reduction of said leakage current.

12. The method of claim 9, said step of forming at least one forward biased diode **characterized by** the steps of:

    forming at least one diffused diode by diffusing n-type and p-type layers in an isolated structure; and
    adjusting doping profile in silicon and programming diode area to control voltage drop across said diode.

**13.** The method of claim 12, further comprising the steps of:

forming at least one integrated polysilicon diode by contact of n-type and p-type polysilicon to underlying silicon of opposite polarity; and

either of preventing the formation of gate oxide underneath transistor gates and removing said gate oxide prior to deposition of polysilicon;

wherein voltage across said diode is adjusted by controlling doping profiles in silicon and programming area of said diode.

**14.** The method of Claim 12, further comprising the step of:

Forming a self-aligned diode control circuit by either depositing polysilicon on top of regions where gate oxide has been prevented from growing during a thermal oxidation cycle, or where said gate oxide has been removed prior to deposition of polysilicon by an appropriate process step.

**15.** The method of claim 8, further **characterized by** the step of:

forming at least a capacitor (2120) connected between the gate terminal (230) and the well terminal (220).

**Patentansprüche**

**1.** Eine Vorrichtung (200), die einen Metalloxidhalbleiter-, MOS-, Transistor aufweist, mit einem Source-Anschluss (240), einem Drain-Anschluss (250), einem Gate-Anschluss (230) und einem Wannen-Anschluss (220), und einer Steuerschaltung (260), die zwischen dem Gate-Anschluss und dem Wannen-Anschluss des MOS-Transistors angeschlossen ist,

wobei die Steuerschaltung (260) eine Polysilizium-Übergang-Diode (265-1) aufweist, wobei die Polysilizium-Übergang-Diode (265-1) den Wannen-Anschluss (220) in dem Ein-Zustand des MOS-Transistors vorwärts vorspannt; wobei die Steuerschaltung (260) eine erste Schwellenspannung in dem MOS-Transistor bewirkt, wenn der MOS-Transistor in einem Aus-Zustand ist, und eine zweite Schwellenspannung in dem MOS-Transistor bewirkt, wenn der MOS-Transistor in einem Ein-Zustand ist, wobei die erste Schwellenspannung betreffend den absoluten Wert höher ist als die zweite Schwellenspannung;

wobei die Vorrichtung (200) **dadurch gekennzeichnet ist, dass**:

die Polysilizium-Übergang-Diode in einer isolierten Struktur ist, die in einem separaten Diffusionsbereich zu dem MOS-Transistor gebildet ist.

**2.** Die Vorrichtung (200) gemäß Anspruch 1, bei der der MOS-Transistor entweder:

eine n-Kanal-Vorrichtung (620) oder eine p-Kanal-Vorrichtung (610) aufweist.

**3.** Die Vorrichtung (200) gemäß Anspruch 1, bei der die Steuerschaltung (260) Folgendes aufweist:

eine oder mehrere vorwärts vorgespannte Übergangsdioden (265-N), die in Reihe mit der vorwärts vorgespannten Übergangsdiode geschaltet sind.

**4.** Die Vorrichtung (200) gemäß Anspruch 1, bei der die Polysiliziumdiode aus einem uniformen Implantat und einem gegenüberliegenden, schweren Implantat besteht.

**5.** Die Vorrichtung (200) gemäß Anspruch 1, bei der die Substratdotierung des MOS-Transistors optimiert ist, um den Leckstrom zu reduzieren.

**6.** Die Vorrichtung (200) gemäß Anspruch 1, ferner **gekennzeichnet durch**:

ein Substrat für den MOS-Transistor, dotiert auf einen Pegel, der den Leckstrom optimiert.

**7.** Die Vorrichtung gemäß Anspruch 1, bei der die Steuerschaltung ferner zumindest einen Kondensator (2120) aufweist, gebildet, um einen ersten Anschluss aufzuweisen, der mit dem Gate-Anschluss (230) verbunden ist, und einen zweiten Anschluss aufzuweisen, der mit dem Wannen-Anschluss (220) verbunden ist.

8. Ein Verfahren zum Reduzieren eines Leckstroms und Erhöhen eines Antriebsstroms in einem Metalloxidhalbleitertransistor (MOS-Transistor), der über einer Wanne (520) gebildet ist, mit einem Source-Anschluss (240), einem Drain-Anschluss (250), einem Gate-Anschluss (230) und einem Wannen-Anschluss (220), wobei das Verfahren durch folgende Schritte gekennzeichnet ist:

Bilden, in einer isolierten Struktur, die in einem separaten Diffusionsbereich zu dem MOS-Transistor gebildet ist, von zumindest einer Polysiliziumdiode (265-1), die zwischen dem Gate-Anschluss (230) und dem Wannen-Anschluss (220) des MOS-Transistors verbunden ist, um den Wannen-Anschluss (230) in dem Ein-Zustand des MOS-Transistors vorwärts vorzuspannen;
wobei eine Steuerschaltung (260) bereitgestellt ist, wobei die Steuerschaltung (260) aus der zumindest einen vorwärts vorgespannten Diode (265) besteht, wobei das Verfahren ferner folgende Schritte aufweist:

Betreiben der Steuerschaltung (260), um zu verursachen, dass der MOS-Transistor eine erste Schwellenspannung in einem Transistor-Aus-Zustand aufweist; und
Betreiben der Steuerschaltung (260), um zu verursachen, dass der MOS-Transistor eine zweite Schwellenspannung in einem Transistor-Ein-Zustand aufweist;
wobei die erste Schwellenspannung im Hinblick auf den absoluten Wert höher ist als die zweite Schwellenspannung.

9. Das Verfahren gemäß Anspruch 8, bei dem der MOS-Transistor entweder eine n-Kanal-Vorrichtung (620) oder eine p-Kanal-Vorrichtung (610) aufweist.

10. Das Verfahren gemäß Anspruch 8, bei dem die Bildung der Polysiliziumdiode folgende Schritte aufweist:

Bilden eines uniformen Implantats; und
Bilden eines gegenüberliegenden schweren Implantats.

11. Das Verfahren gemäß Anspruch 8, das ferner folgenden Schritt aufweist:

Dotieren des Substrats des NMOS-Transistors auf einen Pegel, der für die Reduktion des Leckstroms optimiert ist.

12. Das Verfahren gemäß Anspruch 9, bei dem der Schritt zum Bilden von zumindest einer vorwärts vorgespannten Diode durch folgende Schritte gekennzeichnet ist:

Bilden von zumindest einer diffundierten Diode durch Diffundieren von n-Typ- und p-Typ-Schichten in einer isolierten Struktur; und
Einstellen des Dotierprofils in dem Silizium und Programmieren des Diodenbereichs zum Steuern des Spannungsabfalls über die Diode.

13. Das Verfahren gemäß Anspruch 12, das ferner folgende Schritte aufweist:

Bilden von zumindest einer integrierten Polysiliziumdiode durch einen Kontakt von n-Typ- und p-Typ-Polysilizium mit dem darunter liegenden Silizium mit entgegengesetzter Polarität; und
entweder Verhindern der Bildung eines Gate-Oxids unter den Transistorgates oder Entfernen des Gate-Oxids vor der Aufbringung von Polysilizium;
wobei die Spannung über die Diode eingestellt wird durch Steuern von Dotierungsprofilen in dem Silizium und Programmieren des Bereichs der Diode.

14. Das Verfahren gemäß Anspruch 12, das ferner folgenden Schritt aufweist:

Bilden einer selbstjustierenden Diodensteuerschaltung entweder durch Aufbringen von Polysilizium auf die Regionen, wo verhindert wurde, dass ein Gate-Oxid während eines Wärmeoxidationszyklus wächst, oder wo das Gate-Oxid vor der Aufbringung von Polysilizium durch einen geeigneten Prozessschritt entfernt wurde.

15. Das Verfahren gemäß Anspruch 8, ferner **gekennzeichnet durch** folgenden Schritt:

Bilden von zumindest einem Kondensator (2120), der zwischen den Gate-Anschluss (230) und den Wannen-Anschluss (220) geschaltet ist.

**Revendications**

1. Appareil (200) comprenant un transistor métal-oxyde-semi-conducteur "MOS" présentant une connexion de source (240), une connexion de drain (250), une connexion de porte (230), et une connexion de puits (220), et présentant un circuit de commande (260) connecté entre ladite connexion de porte et ladite connexion de puits dudit transistor MOS,
   ledit circuit de commande (260) comprenant une diode de jonction en polysilicium (265-1), ladite diode de jonction en polysilicium (265-1) déviant vers l'avant ladite connexion de puits (220) à l'état ON (= enclenché) dudit transistor MOS;
   ledit circuit de commande (260) créant une première tension de seuil dans ledit transistor MOS lorsque ledit transistor MOS est à l'état OFF (= déclenché) et une deuxième tension de seuil dans ledit transistor MOS lorsque ledit transistor MOS est à l'état ON, dans lequel ladite première tension de seuil est supérieure en valeur absolue à ladite deuxième tension de seuil;
   ledit appareil (200) étant **caractérisé par le fait que**:

   ladite diode de jonction en polysilicium se situe dans une structure isolée formée dans une zone de diffusion séparée dudit transistor MOS.

2. Appareil (200) selon la revendication 1, dans lequel ledit transistor MOS comprend l'un ou l'autre parmi:

   un dispositif de canal n (620) et un dispositif de canal p (610).

3. Appareil (200) selon la revendication 1, dans lequel ledit circuit de commande (260) comprend:

   une ou plusieurs diodes de jonction déviées vers l'avant (265-N) connectées en série à ladite diode de jonction déviées vers l'avant.

4. Appareil (200) selon la revendication 1, dans lequel ladite diode en polysilicium est composée d'un implant uniforme et d'un implant lourd opposé.

5. Appareil (200) selon la revendication 1, dans lequel le dopage de substrat dudit transistor MOS est optimisé pour réduire ledit courant de fuite.

6. Appareil (200) selon la revendication 1, **caractérisé par** ailleurs par:

   un substrat pour ledit transistor MOS dopé à un niveau optimisant ledit courant de fuite.

7. Appareil selon la revendication 1, dans lequel ledit circuit de commande comprend par ailleurs au moins un condensateur (2120) formé de manière à présenter une première connexion connectée à ladite connexion de porte (230) et une deuxième connexion connectée à ladite connexion de puits (220).

8. Procédé pour réduire le courant de fuite et augmenter le courant d'attaque dans un transistor métal-oxyde-semi-conducteur (MOS) formé au-dessus d'un puits (520) présentant une connexion de source (240), une connexion de drain (250), une connexion de porte (230) et une connexion de puits (220), ledit procédé étant **caractérisé par** les étapes consistant à:

   former dans une structure isolée formée dans une zone de diffusion séparée dudit transistor MOS au moins une diode en polysilicium (265-1) connectée entre ladite connexion de porte (230) et ladite connexion de puits (220) dudit transistor MOS, pour dévier vers l'avant ladite connexion de puits (230) à l'état ON dudit transistor MOS; dans lequel est prévu un circuit de commande (260), ledit circuit de commande (260) étant composé de l'au moins une diode déviée vers l'avant (265), ledit procédé comprenant par ailleurs les étapes consistant à:
   faire fonctionner ledit circuit de commande (260) pour faire que ledit transistor MOS présente une première tension de seuil à l'état OFF du transistor; et
   faire fonctionner ledit circuit de commande (260) pour faire que ledit transistor MOS présente une deuxième tension de seuil à l'état ON du transistor;
dans lequel ladite première tension de seuil est supérieure en valeur absolue à ladite deuxième tension de seuil.

9. Procédé selon la revendication 8, ledit transistor MOS comprenant l'un ou l'autre parmi:

un dispositif de canal n (620) et un dispositif de canal p (610).

10. Procédé selon la revendication 8, dans lequel la formation de ladite diode en polysilicium comprend les étapes consistant à:

former un implant uniforme; et
former un implant lourd opposé.

11. Procédé selon la revendication 8, comprenant par ailleurs l'étape consistant à:

doper le substrat dudit transistor NMOS à un niveau optimisé pour la réduction dudit courant de fuite.

12. Procédé selon la revendication 9, ladite étape de formation d'au moins une diode déviée vers l'avant étant **caractérisée par** les étapes consistant à:

former au moins une diode diffusée en diffusant des couches de type n et de type p dans une structure isolée; et
ajuster le profil de dopage dans le silicium et programmer la zone de diode de manière à contrôler la chute de tension dans ladite diode.

13. Procédé selon la revendication 12, comprenant par ailleurs les étapes consistant à:

former au moins une diode de polysilicium intégrée par contact du polysilicium de type n et de type p avec le silicium sous-jacent de polarité opposée; et
l'un ou l'autre parmi éviter la formation d'oxyde de porte sur les portes de transistor et éliminer ledit oxyde de porte avant le dépôt de polysilicium;
dans lequel la tension dans ladite diode est ajustée en contrôlant les profils de dopage dans le silicium et un programmant la zone de ladite diode.

14. Procédé selon la revendication 12, comprenant par ailleurs l'étape consistant à:

former un circuit de commande de diode auto-aligné soit en déposant du polysilicium au-dessus des régions où l'oxyde de porte a été empêché de croître pendant un cycle d'oxydation thermique, ou dans lequel ledit oxyde de porte a été enlevé avant le dépôt de polysilicium par une étape de processus appropriée.

15. Procédé selon la revendication 8, **caractérisé par** ailleurs par l'étape consistant à:

former au moins un condensateur (2120) connecté entre la connexion de porte (230) et la connexion de puits (220).

FIGURE 1 (PRIOR ART)

FIGURE 2

260

265-1

265-N

FIGURE 3

Source     Gate     Drain

Diode

Silicide

Silicide

Polysilicon gate

Gate Oxide

P+

N+

P+

N+

N+

n-well

p-well

N-layer

p Substrate

FIGURE 4A

FIGURE 4B

FIGURE 4C

Source  Gate  Drain

Diode

P+ Poly

N+ Poly

Silicide

Polysilicon gate

Gate oxide

P+  N+  N+

p-well

N-layer

p substrate

FIGURE 4D

Schottky Diode

Silicide

Polysilicon gate

Gate oxide

N+  P+  N+  N+

n-well  p-well

FIGURE 4E

500

570

560

y

x

510

z

540

550

530

520

FIGURE 5

Vdd

600

PMOS

Zcp

615

610

Vin

Vout

620

NMOS

625

Zcn

FIGURE 6

Vdd

PMOS

Zcp

710                715

Vin1

Vin2

PMOS

Zcp

720                725

Vout

730

735

NMOS

Zcn

740                745

NMOS

Zcn

700

FIGURE 7

A

NMOS

820

800

Zcn

825

Vin

Vout

815

Zcp

PMOS    810

A̅

FIGURE 8

FIGURE 9 (PRIOR ART)

FIGURE 10

BL(0)   BL(1)   BL(2)   BL(3)   BL(4)   BL(5)   BL(6)   BL(7)

1130   1131   1132   1133   1134   1135   1136   1137

1120   1110   1111   1112   1113   1114   1115   1116   1117   1128

1126

1122   1140

FIGURE 11

1246   1247   1212   $V_{DD}$   1214   1249   1248

1232

N-well

1227   1229

1245   1235

P-well

1240

1230   1226   1222   1224   1228   1234

1244

FIGURE 12

FIGURE 13

FIGURE 14

1500

1510

1570

1520

1525

1530

1540

1550

1535

1545

1560

FIGURE 15 (Prior Art)

Drain-source current

Gate biasing diode
forward current

Current (log scale)

Gate biasing diode
forward current

Gate tunneling current

Voltage

FIGURE 16

Diode       NMOS transitor

Diode       PMOS transitor

FIGURE 17

1800

1510

1570

1520

1530       1540

1550       1560

1535       1820       1545       1525

1810

FIGURE 18

FIGURE 19A

FIGURE 19B

Drain

Gate

Silicide

Polysilicon - 2 (P+ or N-)

N+ Polysilicon gate

Source

Silicide

P+

N+

N+

n-well

p-well

FIGURE 20A

Drain

Gate

Silicide

Polysilicon-2 (N+ or P-)

P+ Polysilicon gate

Source

Silicide

N+

P+

P+

n-well

n-well

FIGURE 20B

Drain

Gate

Silicide

Polysilicon-2 (N+ or P-)

P+ Polysilicon gate

Silicide

Source

N+

P+

inter-poly oxide

P+

Gate oxide

n-well

FIGURE 20C

260-A

2120

2110

FIGURE 21A

260-B

2121

2111

2140

2130

FIGURE 21B

FIGURE 21C

FIGURE 21D

Well

C | Diode

Source

Gate

Drain

FIGURE 22

2310 ⌐          ⌐2320          2340
silicide          silicide          silicide

N+ gate region          P- N+          P- N+
conductor          diode          conductor          diode          conductor
                                                                    ⌐2330

FIGURE 23

2410 ⌐          ⌐2420          2440
silicide          silicide

N+ gate region          P- N+
conductor          capacitor using gate oxide          diode          conductor
                                                        ⌐2430

FIGURE 24

2600

2530

2560    Z_C

2540    2520    2550

2570

Negative biasing circuit

FIGURE 25

2600

Vdd

PMOS

Zcp

2615

2640

Positive Biasing Circuit

2610

Vin

2620

Vout    2630

2625

Negative Biasing Circuit

NMOS

Zcn

FIGURE 26

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5821769 A, Douseki
- US 2002017678 A1
- US 6787850 B1

**Non-patent literature cited in the description**

- **TAKAMIYA ; TAKAMIYA et al.** *High Performance Electrically Induced Body Dynamic Threshold SOI MOSFET (EIB-DTMOS) with Large Body Effect and Low Threshold Voltage*
- **VORA.** A 2 Micron High Performance Bipolar 64K ECL Static RAM Technology With 200 Square Microns Contactless Memory Cell. *IEDM Technical Digest,* 1984, 690-693